# FASCICULE DE BREVET EUROPEEN

(11) **EP 3 477 709 B1**
(45) Date de publication et mention de la délivrance du brevet: **25.03.2020**
(21) Numéro de dépôt: 18202604.7
(22) Date de dépôt: 25.10.2018
(51) Int. Cl.: H01L 31/08

(54) **COMMUTATEUR**
UMSCHALTER
SWITCH

(30) Priorité: 30.10.2017 FR 1701129
(43) Date de publication de la demande: 01.05.2019
(73) Titulaire: Thales, 92400 Courbevoie (FR)
(72) Inventeur: CANAL, Yves, 78000 ELANCOURT (FR); TRIPON-CANSELIET, Charlotte, 75005 PARIS (FR); CHAZELAS, Jean, 78000 ELANCOURT (FR)
(74) Mandataire: Derval, Estelle

(56) Documents cités:
- FR-A1- 3 000 327

## Description

La présente invention concerne les commutateurs à commande optique du type comprenant une ligne de transmission comprenant deux portions de lignes séparées par un gap et reliées par une zone d'interruption de ligne photoconductrice, dite zone active, dont la conduction est commandée par effet photoélectrique au moyen d'un faisceau optique illuminant cette zone. Le commutateur peut être dans un état passant, ou ouvert, dans lequel la continuité électrique de la ligne de transmission est assurée, lorsque la zone active est éclairée par un faisceau optique, ou dans un état bloquant, ou fermé, dans lequel la continuité électrique de la ligne de transmission n'est pas assurée, lorsque la zone active n'est pas éclairée.

Ces commutateurs peuvent, par exemple, être utilisés en tant que photo-commutateurs, photo-interrupteurs, phototransistors, photo-mélangeurs, déphaseurs ou échantillonneurs. Dans le cas d'une utilisation en tant qu'échantillonneurs, une ligne de transmission hyperfréquence est interrompue par le commutateur commandé par signal optique de référence qui commute entre les états passant et bloquant à des instants bien précis, de manière cadencée, afin d'échantillonner un signal électrique hyperfréquence injecté sur la ligne de transmission hyperfréquence.

L'invention s'applique tout particulièrement au domaine des hyperfréquences. Pour rappel, la bande de fréquence des signaux hyperfréquences est de l'ordre de quelques gigahertz (GHz) à quelques centaines de GHz. De nombreuses applications dans les domaines des télécommunications et des radars utilisent de tels signaux hyperfréquences. Pour réaliser les fonctions précitées dans le domaine des hyperfréquences, le commutateur doit présenter un temps de réponse rapide de l'ordre de la picoseconde avec un contraste maximal entre l'état ouvert l'état fermé.

Il a été démontré récemment qu'un accroissement des performances des photo-interrupteurs hyperfréquences (diminution du facteur de bruit, en particulier) passe par la miniaturisation des dimensions des interruptions de lignes jusqu'à des dimensions de l'ordre de grandeur du micromètre, qui rend plus difficile l'apport suffisant d'énergie optique sur la zone active de l'interrupteur. Or, si l'énergie lumineuse arrivant sur la zone active du commutateur est insuffisante, ce dernier présente des temps de commutation ON/OFF rédhibitoires, ainsi qu'un contraste faible entre ses 2 états du commutateur. On cherche donc à réaliser un couplage optique maximum entre le faisceau optique de commande et le commutateur, c'est-à-dire à apporter la plus grande proportion possible du faisceau optique émis sur la zone active.

Les dispositifs de commutation comprennent ainsi classiquement des composants optiques permettant d'acheminer le faisceau optique de commande vers la zone active du commutateur. Ces moyens d'acheminement sont interposés, sur le chemin du faisceau optique, entre la source optique (laser en général, par exemple une diode laser) et la zone active. Ces moyens d'acheminement comprennent classiquement une fibre optique monomode permettant de guider le faisceau optique de commande et une lentille optique convergente destinée à focaliser le faisceau optique sur la zone active. Les composants optiques permettent d'optimiser la puissance optique de commande en focalisant un maximum de lumière dans la zone active. Pour une dimension du faisceau optique étant de l'ordre du micromètre, tout comme celle de la zone active, il est nécessaire de positionner la tâche, formée par le faisceau optique sur le composant optique, par rapport au centre de la zone active de l'interrupteur avec une précision de 0, 1 microns.

Or, il n'est pas possible de venir accoler ces composants optiques au commutateur. En effet, un tel contact induit une modification du champ électromagnétique conduisant à une modification de la fonction de transfert de la ligne hyperfréquence du commutateur. Il est donc nécessaire de conserver une distance suffisante entre la lentille et la zone active correspondant à la distance focale de la lentille ce qui rend plus difficile le positionnement des moyens d'acheminement par rapport à la zone active.

Il est connu de disposer une fibre optique lentillée (fibre optique munie d'une lentille convergente solidaire d'une extrémité de la fibre optique) dans une tranchée réalisée dans un substrat de silicium, la tranchée présentant un profil en V faisant face à un composant optoélectronique, comprenant la ligne de transmission hyperfréquence, également fixé sur le substrat. Les propriétés du V (dimensions, inclinaison) sont très précises puisqu'elles sont définies en fonction des caractéristiques cristallographique du silicium. Cette précision permet d'obtenir la précision de positionnement relatif souhaité, entre l'extrémité de la fibre optique lentillée et la zone active, dans le plan de la zone active. La position optimale de l'extrémité de la fibre optique, selon un axe perpendiculaire au plan de la zone active, est obtenue par mesure d'un coefficient de transmission maximal d'un signal véhiculée sur la ligne hyperfréquence au travers du dispositif de commutation. La fibre optique est alors fixée de façon définitive sur le support dans la position optimale.

Une autre solution consiste à venir rapporter un outillage permettant de régler la position relative de la fibre optique et de la zone active, la position optimale étant obtenue par la mesure du coefficient de transmission sur la ligne hyperfréquence au travers du commutateur, l'outillage permettant de maintenir la fibre optique pendant un temps suffisant dans la position optimale pour permettre de venir fixer la fibre optique dans cette position par rapport à la zone active.

Or, le contrôle de la position optimale par le coefficient de transmission dépend de la fréquence du signal transmis sur la ligne de transmission hyperfréquence. Cette mesure nécessite de disposer d'un banc de mesure hyperfréquence muni d'un générateur et d'un récepteur de signal hyperfréquence.

Par ailleurs, les dispositifs optiques actuels fournissent un faisceau focalisé de taille supérieure à la zone active du dispositif dans le plan de la zone active. Le diamètre du faisceau est généralement de l'ordre de 2 micromètres dans la zone active. Le maximum de transmission ne permet d'obtenir la précision de positionnement relatif suffisante ni dans le plan de la zone active, ni dans la direction perpendiculaire à ce plan.

Par ailleurs, en supposant que la position relative des éléments optiques (par exemple une fibre optique munie d'une lentille ou fibre optique lentillée) par rapport à la zone active est inconnue avant réglage, on ne dispose d'aucun indicateur autre que le maximum de signal transmis pour faire converger rapidement l'alignement entre ces deux éléments. On fonctionne alors avec le risque de venir endommager les composants optiques, par exemple la fibre optique lentillée, par contact avec le dispositif.

Le document FR3000327 divulgue un dispositif de commutation de signaux hyperfréquences connu.

Un but de l'invention est de limiter au moins un des inconvénients précités.

A cet effet, l'invention se rapporte à un commutateur comprenant un substrat semi-conducteur et une ligne hyperfréquence comprenant deux pistes conductrices réalisées sur le substrat, les deux pistes conductrices étant séparées par un gap assurant une isolation électrique entre les deux pistes conductrices, une zone active du substrat étant délimitée par les deux pistes conductrices et reliant les deux pistes conductrices, la zone active étant planaire, définissant un plan de la zone active, présentant un centre O, le substrat étant apte à être rendu localement conducteur lorsque la zone active est éclairée par un faisceau optique de commande de sorte à établir un contact électrique entre les deux pistes de la ligne hyperfréquence. Selon l'invention, le commutateur comprend en outre un ensemble d'au moins une ligne, dite ligne continue, destinée à acheminer un courant continu, la ligne continue comprenant deux électrodes distantes l'une de l'autre de sorte qu'une isolation électrique est assurée entre les deux électrodes, les électrodes étant reliées par une zone de séparation du substrat, la zone de séparation étant apte à être rendue conductrice lorsqu'elle est éclairée par le faisceau optique de commande de sorte à établir un contact électrique entre les deux électrodes, les deux électrodes étant séparées par un plan de séparation de la ligne continue, le plan de séparation passant par le centre O et perpendiculaire au plan de la zone active.

Avantageusement, le commutateur comprend au moins une des caractéristiques ci-dessous prises seules ou en combinaison :
- les deux électrodes comprennent chacune une terminaison dite terminaison centrale de la ligne continue, les terminaisons centrales des deux électrodes de la ligne continue étant disposées en regard l'une de l'autre sur une droite d'alignement de la ligne continue,
- la droite d'alignement de la ligne continue est perpendiculaire au plan de séparation de la ligne continue de façon symétrique par rapport au plan de séparation de la ligne continue,
- l'ensemble comprend deux lignes continues dont les droites d'alignement respectives sont perpendiculaires entre elles,
- l'ensemble comprend plusieurs lignes continues, dont deux lignes continues présentant le même plan de séparation, les terminaisons centrales de chacune des deux lignes continues présentant le même plan de séparation étant disposées de façon symétrique par rapport au plan de séparation sur une droite d'alignement de la ligne continue perpendiculaire au plan de séparation, les droites d'alignement des deux lignes continues étant disposées de façon symétrique par rapport à un autre plan passant par le centre, perpendiculaire au plan de la zone active et au plan de séparation,
- l'ensemble comprend un premier sous-ensemble d'au moins une ligne continue et un deuxième sous-ensemble d'au moins une ligne continue, les terminaisons centrales des électrodes des lignes continues du premier sous-ensemble et du deuxième sous-ensemble étant disposées sur des cercles concentriques dont le centre est situé sur un axe perpendiculaire au plan de la zone active et passant par le centre O,
- le plan de séparation de la ligne continue du premier sous-ensemble est le plan de séparation de la ligne continue du deuxième sous-ensemble, les deux terminaisons centrales de la ligne continue du premier sous-ensemble étant disposées de l'autre côté d'un autre plan passant par le centre O, perpendiculaire au plan de la zone active et au plan de séparation par rapport aux terminaisons centrales de la ligne continue du deuxième sous-ensemble,
- la droite d'alignement d'au moins une ligne continue passe par un axe perpendiculaire au plan de la zone active et passant par le centre O,
- la zone active et la zone de séparation sont réalisées dans des matériaux différents,
- la zone active comprend des porteurs de durée de vie inférieure à une durée de vie des porteurs de la zone de séparation.

L'invention se rapporte étalement à un procédé de fabrication d'un commutateur selon l'invention. Le procédé comprend les étapes de disposer les pistes conductrices sur le substrat de façon qu'elles soient séparées par le gap, et de façon qu'elles délimitent et soient reliées par la zone active, et de disposer les électrodes de la ligne continue sur le substrat de façon qu'elles soient distantes l'une de l'autre de sorte qu'une isolation électrique est assurée entre les deux électrodes et de sorte qu'elles soient reliées par la zone de séparation du substrat, et séparées par le plan de séparation.

L'invention se rapporte également à un dispositif de commutation comprenant un commutateur selon l'invention et une source générant le faisceau optique de commande et/ou des moyens d'acheminement comprenant au moins un composant optique permettant d'acheminer le faisceau optique de commande jusqu'à la zone active.

Avantageusement, le dispositif de commutation comprend un dispositif d'actionnement permettant de modifier une position de la source optique et/ou d'au moins une partie d'au moins un composant optique des moyens d'acheminement par rapport à la zone active.

Avantageusement le dispositif de commutation comprend au moins un capteur permettant de mesurer une propriété électrique de la zone de séparation entre des terminaisons centrales des deux électrodes de la ligne continue, le dispositif de réglage étant apte à régler une position de la source optique et/ou d'au moins une partie d'au moins un composant optique des moyens d'acheminement par rapport à la zone active à partir d'au moins une mesure de la propriété électrique.

Avantageusement, le dispositif de commutation est configuré pour mettre en oeuvre une étape d'alignement lorsqu'une condition de mise en oeuvre de l'étape d'alignement est respectée, le dispositif de commutation étant configuré pour mettre en oeuvre les étapes suivantes lors de la mise en œuvre de l'étape d'alignement:
- mesurer la propriété électrique de la zone de séparation entre les terminaisons centrales de la ligne continue au moyen du capteur,
- régler la position de la source et/ou d'au moins une partie d'au moins un composant optique des moyens d'acheminement relativement à la zone active à partir d'une mesure de la propriété électrique issue du capteur, au moyen du dispositif de réglage.

L'invention se rapporte également à un procédé d'alignement de la source et/ou d'au moins une partie d'au moins un composant optique des moyens d'acheminement par rapport à la zone active d'un dispositif de commutation selon l'invention, ledit procédé comprenant les étapes suivantes :
- mesurer la propriété électrique de la zone de séparation entre les terminaisons centrales de la ligne continue,
- régler la position de la source et/ou d'au moins une partie d'au moins un composant optique des moyens d'acheminement relativement à la zone active à partir de ladite mesure.

D'autres caractéristiques, buts et avantages de la présente invention apparaîtront à la lecture de la description détaillée qui va suivre et en regard des dessins annexés donnés à titre d'exemples non limitatifs et sur lesquels :
- la figure 1, une illustration schématique d'une chaîne de réception ;
- les figures 2a et 2b, illustres schématiquement en vue de dessus (figure 2a) et en coupe selon le plan de coupe AA' de la figure 2a (figure 2b), le commutateur selon l'invention dans lequel les lignes continues ne sont pas référencées pour plus de clarté,
- les figures 3a et 3b illustrent schématiquement en vue de dessus le commutateur selon l'invention muni de moyens de mesure (figure 3b) et en coupe selon le plan de coupe BB' de la figure 3a (figure 3b),
- les figures 4a à 4c illustrent schématiquement les étapes du procédé de fabrication du dispositif de commutation selon l'invention,
- la figure 5 illustre schématiquement des éléments du dispositif de commutation selon l'invention,
- les figures 6a et 6b illustrent schématiquement en perspective (figure 6a) et en vue de côté (figure 6b) le dispositif de commutation selon l'invention,
- la figure 7 illustre schématiquement en perspective le support intermédiaire fixé à un support fixe,
- la figure 8 illustre schématiquement une vue éclatée du support intermédiaire et du support fixe,
- les figures 9 et 10 illustrent schématiquement le support intermédiaire.

D'une figure à l'autre les mêmes éléments sont désignés par les mêmes références.

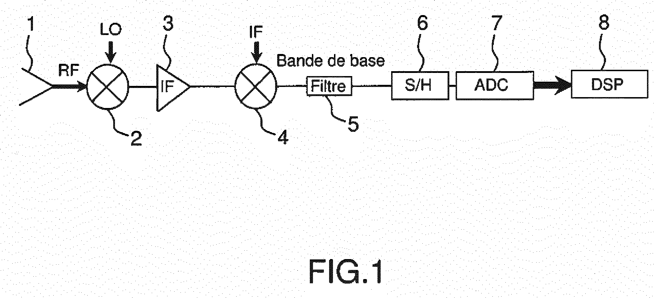

La figure 1 illustre, de façon schématique, une chaîne de réception classique, utilisé dans de nombreux systèmes actuels. En raison des limitations intrinsèques de la bande passante accessible par les convertisseurs analogique-numériques en cours de développement, les chaînes de réception hyperfréquence requièrent des fonctions de transposition complexes et coûteuses sans autre alternative. Ainsi, la chaîne de réception de la figure 1 comporte en sortie de l'antenne de réception 1 du signal hyperfréquence un premier mélangeur 2 ramenant la fréquence du signal dans une bande de fréquence intermédiaire. Un deuxième mélangeur 4 transpose le signal amplifié 3 en bande de base pour être échantillonné en haute fréquence par un échantillonneur-bloqueur 6 après filtrage 5 par exemple. Le signal échantillonné est converti numériquement par un convertisseur 7, le signal numérique étant pris en compte par des moyens de traitement 8.

Les systèmes futurs, encore plus que les systèmes actuels, nécessiteront de réaliser des récepteurs fonctionnant soit à très haute fréquence, à plusieurs dizaines de GHz, soit à très large bande passante instantanée, par exemple 20 GHz. De tels récepteurs nécessitent des fonctions de commutations très performantes. Des dispositifs de commutations à commande optique, capables de commuter très rapidement, peuvent répondre à ces fréquences de fonctionnement à conditions qu'ils présentent des performances suffisantes au niveau du contraste ON/OFF, supérieur à 50 dB par exemple. Il faut aussi qu'ils présentent des performances suffisantes en ce qui concerne la puissance optique nécessaire et les pertes d'insertions pour permettre un fonctionnement acceptable en termes de consommation d'énergie. De tels dispositifs de commutation constituent une fonction de commutation élémentaire pour des composants de la chaîne de réception, tels que les échantillonneurs-bloqueurs par exemple. Ils peuvent aussi être utilisés pour réaliser des mélangeurs, des déphaseurs et autres composants précités nécessitant une fonction de commutation élémentaire ultrarapide performante.

L'invention se rapporte à un dispositif optoélectronique du type dispositif de commutation à commande optique et à un commutateur à d'un tel dispositif de commutation.

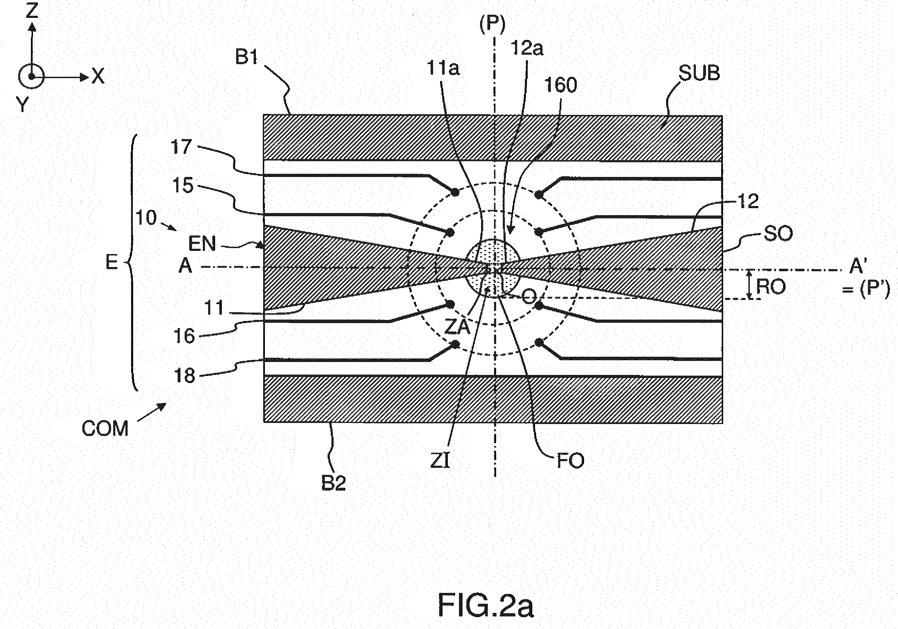

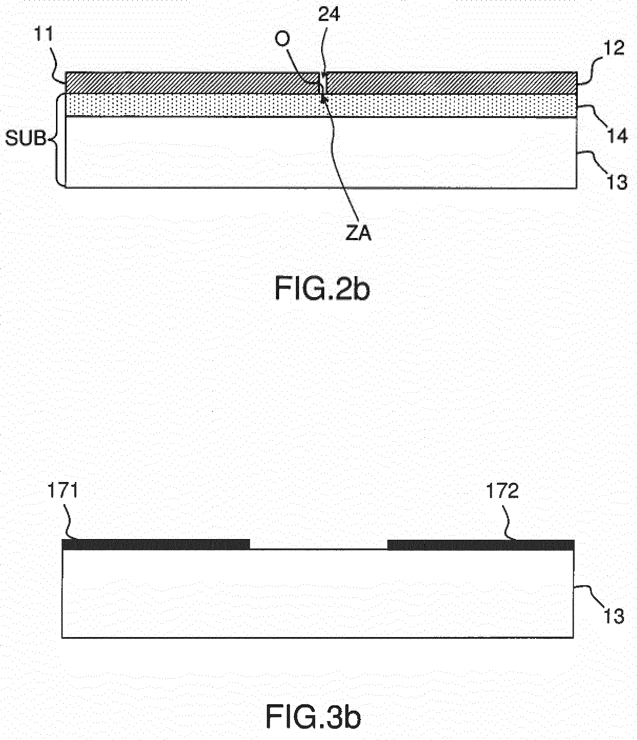

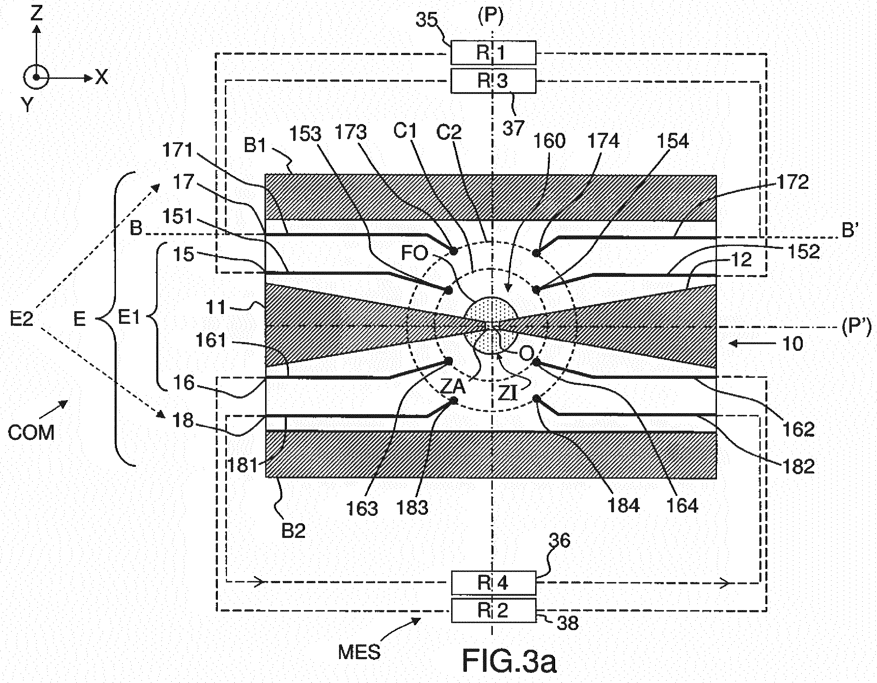

Les figures 2a et 2b et 3a et 3b représentent schématiquement en vue de dessus (2a et 3a) et en coupe selon le plan de coupe AA' de la figure 2a (figure 2b) et selon le plan de coupe BB' de la figure 3a (figure 3b), un exemple de commutateur COM selon l'invention, toutes les références n'apparaissant pas sur ces figures pour plus de clarté. Le commutateur COM de la figure 3a est muni de moyens de mesure.

Le commutateur COM comprend une ligne de transmission 10 comprenant deux pistes conductrices 11 et 12 disposées sur un substrat SUB. Ces pistes 11 et 12 sont distantes l'une de l'autre et séparées par un espace encore appelé gap 24 ne portant pas de métallisation de sorte à assurer une isolation électrique entre les deux pistes conductrices 11 et 12. Les deux pistes délimitent une zone active ZA du substrat sensiblement planaire, définissant un plan dit de la zone active (x, y). La zone active ZA présente un centre O. Les deux pistes conductrices 11 et 12 délimitent la zone active ZA qui relie ces deux pistes. Un contact électrique entre les deux pistes conductrices 11 et 12 est apte à être réalisé en éclairant la zone active ZA au moyen d'un faisceau optique de commande FO de longueur d'onde prédéterminée. Le substrat SUB est alors rendu conducteur électriquement dans la zone éclairée par injection de porteurs dans la zone éclairée. Les deux pistes 11 et 12 sont isolées électriquement en l'absence d'éclairage de la zone active ZA par le faisceau électrique de commande FO.

L'axe y est perpendiculaire au plan x, z de la zone active ZA.

La ligne de transmission 10 comprend également des bandes conductrices B1, B2 disposées de chaque côté des pistes conductrices 11, 12, et sont reliées à un potentiel de masse formant ainsi des plans de masse. Le commutateur COM représenté sur les figures 2a à 3b est de type coplanaire.

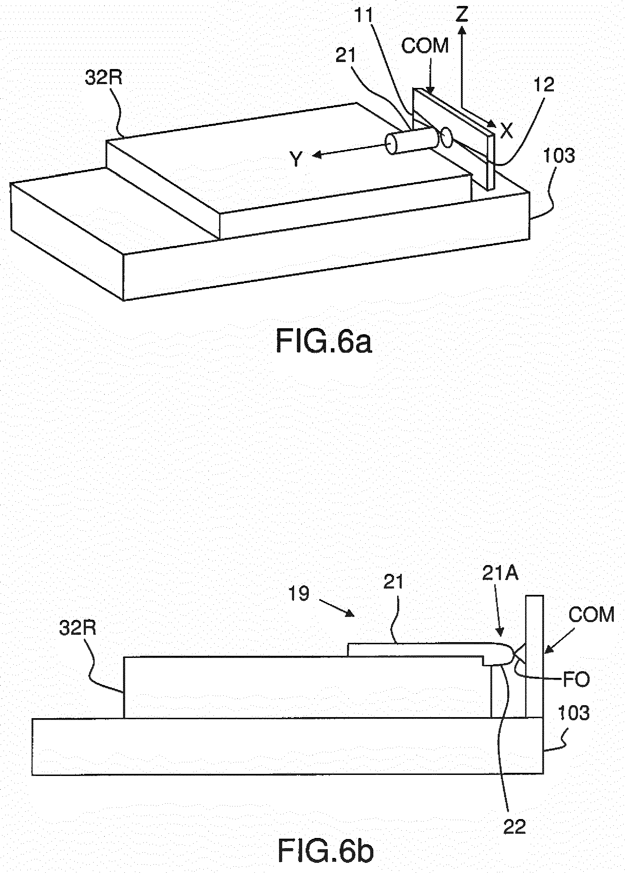

Afin de réaliser la fonction de commutation on éclaire la zone active ZA de l'énergie au moyen du faisceau optique de commande FO (visible sur la figure 6b) de longueur d'onde prédéterminée telle que le faisceau FO rend le substrat SUB localement conducteur entre les deux pistes conductrices 11, 12, et qu'une continuité électrique soit établie entre les deux pistes 11 et 12, correspondant à l'état passant du commutateur COM. Un signal injecté sur une des deux pistes de la ligne de transmission est alors recueilli sur l'autre piste. Inversement si la zone active ZA cesse d'être éclairée, le substrat SUB cesse par là même d'être conducteur entre les deux pistes 11 et 12 et la continuité électrique est interrompue entre les deux pistes 11 et 12, le commutateur COM étant alors à l'état bloquant. Un signal injecté sur une des deux pistes 11, 12 de la ligne de transmission 10 n'est alors pas recueilli sur l'autre piste.

La zone du commutateur COM éclairée par le faisceau optique de commande FO est appelée zone d'interaction ZI dans la suite du texte. Elle englobe la zone active ZA lorsque le commutateur est dans l'état passant.

Le substrat semi-conducteur SUB comprend par exemple au moins deux couches. Une première couche 13 sert de support. Afin d'obtenir des temps de réponse très courts, cette première couche 13 est avantageusement complétée en surface par une deuxième couche 14 de semi-conducteur réalisée dans un matériau comprenant des porteurs présentant des porteurs de durée de vie plus courte que les porteurs de la première couche 13. Les pistes 11, 12 sont déposées sur la deuxième couche 14. La première couche 13 est par exemple constituée d'arséniure de gallium semi-isolant noté AsGa SI et la deuxième couche 14 est par exemple réalisée en arséniure de gallium épitaxié à basse température BT (AsGa BT). La deuxième couche 14 peut par ailleurs être dopée.

En variante, la première couche 13 et la deuxième couche 14 peuvent être réalisés dans des matériaux semi-conducteurs différents de l'AsGa SI et du l'AsGa comme par exemple le silicium Si, l'InP, etc....

Dans l'exemple non limitatif des figures 2a et 3b, la zone active ZA est une partie d'une face, dite avant, du substrat SUB. La zone active ZA, ne porte pas de métallisation et est située en regard du gap 24.

En variante, la configuration du commutateur est du type microruban, c'est-à-dire qu'il n'y a pas de plan de masse de chaque côté des pistes conductrices 11, 12 mais un plan de masse situé en face arrière du substrat 13, 14. La face arrière du substrat 13, 14 est la face de ce substrat 13 qui est opposée aux pistes conductrices 11, 12.

L'invention trouve son application dans le domaine des hyperfréquences. La ligne de transmission 10 est configurée pour permettre de transmettre un signal hyperfréquence d'un port d'entrée EN au port de sortie SO du dispositif de commutation. A cet effet, les formes, et les dimensions des pistes 11 et 12 ainsi que l'espacement entre les pistes 11 et 12 et le positionnement des bandes conductrices B1 et B2 sont définis de façon que les impédances d'entrée et de sortie de la ligne hyperfréquence du commutateur à l'état passant soient adaptées à l'impédance de ligne caractéristique des lignes hyperfréquences standards, c'est-à-dire de 50 Ohms ou 75 Ohms. Les impédances d'entrée et de sortie du dispositif à l'état passant sont en pratique comprises entre 50 Ohms et 75 Ohms comme dans les commutateurs classiques.

Les pistes conductrices 11 et 12 peuvent avantageusement, mais non nécessairement, présenter un profil particulier tel que les impédances d'entrée et de sortie du commutateur soient désadaptées à l'impédance caractéristique d'une ligne hyperfréquence lorsque le commutateur est à l'état ouvert. Ainsi le contraste entre l'état passant et l'état ouvert (ON/OFF) par augmentation des pertes d'insertion et de transmission s'ajoute à l'impédance hautement résistive de la zone d'interaction. Le gap est alors dimensionné en longueur et en largeur pour obtenir cet effet comme cela est décrit dans la demande de brevet FR 3000327. A cet effet, partant des ports d'entrée EN et de sortie SO, les pistes décroissent en largeur jusqu'au au niveau du gap 24 séparant ces deux pistes 11 et 12. Avantageusement, la largeur des pistes au niveau du gap (largeur du gap) est dans le même ordre de grandeur que la longueur du gap. La largeur et la longueur gap sont par exemple de l'ordre de 0,2 micromètres. La largeur des pistes au niveau du gap est de préférence comprise entre 0,1 et 0,5 micromètre. Et la longueur du gap est de préférence entre 0,1 et 0,5 micromètre. Lors de l'éclairement, l'impédance de la zone active ZA passe de quelques MOhms, à l'état ouvert, à quelques dizaines d'ohms à l'état passant. Cette impédance devient alors compatible avec l'impédance d'accès des pistes choisie pour la désadaptation à l'état ouvert (OFF), réduisant ainsi les réflexions de signaux le long du dispositif.

Selon l'invention, comme visible sur la figure 3a, le commutateur comprend, en plus de la ligne de transmission 10, un ensemble E d'au moins une ligne conductrice, apte à conduire de l'électricité, appelée ligne continue dans la suite du texte, destinée à acheminer un signal continu. L'ensemble E comprend quatre lignes continues 15, 16, 17, 18 dans l'exemple non limitatif des figures. De façon générale, l'ensemble E comprend une ou plusieurs lignes continues.

Chaque ligne comprend deux électrodes ou pistes conductrices 151 et 152 ; 161 et 162 ; 171 et 172 ; 181 et 182 distantes l'une de l'autre de sorte à être isolées électriquement l'une de l'autre. Les électrodes des lignes continues sont formées sur une couche du substrat SUB. Les électrodes de chacune des lignes continues sont reliées par une zone de séparation 160 du substrat SUB photoconductrice. Une continuité électrique est établie entre les deux électrodes 151 et 152 ou 161 et 162 ou 171 et 172 ou 181 et 182 d'une ligne continue lorsque la zone de séparation 160 est éclairée par le faisceau optique FO de commande depuis une terminaison dite centrale 153, 163, 173 ou 183 de la première électrode 151, 161, 171 ou 181 jusqu'à une terminaison dite centrale 154, 164, 174 ou 184 de l'autre électrode 152, 162, 172 ou 182 de la même ligne. Dans ce cas, la partie de la zone de séparation 160 qui est délimitée par les deux terminaisons centrales de la même ligne continue est totalement éclairée. La ligne continue est alors dans un état passant ou fermé. Le faisceau optique de commande FO génère un courant circulant dans la ligne continue. Le contact électrique entre les deux électrodes d'une même ligne continue est supprimé lorsque la zone de séparation 160 n'est plus éclairée. La ligne continue est alors dans un état bloquant ou ouvert. Avantageusement, la ligne est inapte à transmettre un signal hyperfréquence à travers le commutateur.

Les deux terminaisons centrales d'une même ligne continue sont situées en regard l'une de l'autre. Ce sont les terminaisons des deux électrodes d'une même ligne continue qui sont les plus proches l'une de l'autre et les plus proches du centre O.

Selon l'invention, les deux électrodes 151 et 152,161 et 162,171 et 172 ou 181 et 182 d'une même ligne continue de mesure 15, 16, 17 ou 18 sont séparées l'une de l'autre par un plan de séparation P passant par le centre O et perpendiculaire au plan de la zone active ZA, c'est-à-dire au plan (x,z).

Autrement dit, les terminaisons centrales 153 et 154 ; 163 et 164 ; 173 et 174 ou 183 et 184 des deux électrodes 151 et 152 ; 161 et 162 ; ou 171 et 172 d'une même ligne continue 15, 16, 17 ou 18 sont séparées par le plan de séparation P de la ligne continue. Une des terminaisons centrales de la ligne continue est située d'un côté du plan de séparation P de la ligne continue et l'autre terminaison centrale de la même ligne est située de l'autre côté de ce plan de séparation P.

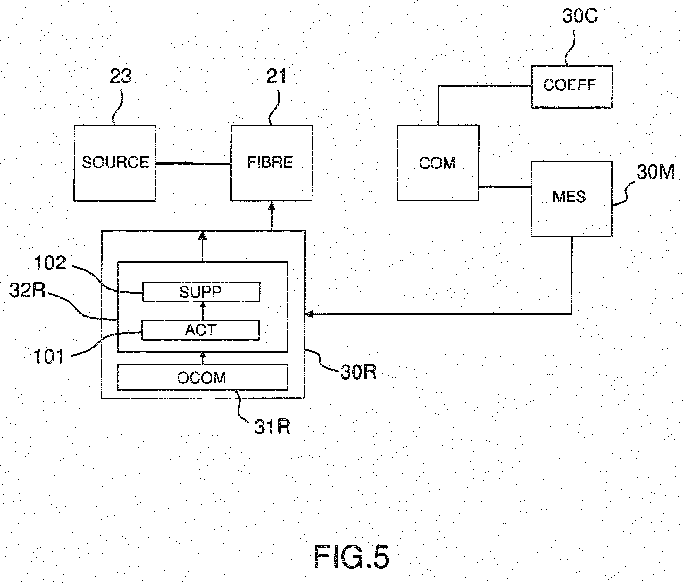

De cette façon, une valeur d'une propriété électrique du matériau formant la zone de séparation 160 mesurée entre les terminaisons centrales des deux électrodes d'une même ligne continue est représentative de l'éclairement de la zone de séparation entre ces deux terminaisons. La valeur de la propriété électrique est ainsi représentative de la position de la zone d'interaction ZI par rapport à la zone active ZA selon la direction droite sur laquelle sont disposées les terminaisons centrales de la ligne, c'est-à-dire selon direction x sur la réalisation non limitative des figures. En prévoyant un dispositif de mesure MES, 30M (représenté sur la figure 5) comprenant des moyens de mesure 35, 36, 37, 38, permettant de mesurer de la valeur de la propriété électrique pour au moins une ligne, tels que représentés en pointillés sur la figure 3a, il est alors possible d'utiliser la mesure de la propriété électrique pour contrôler et ainsi régler la position de la zone d'interaction ZI par rapport à la zone active ZA selon la direction x. Les électrodes d'une même ligne continue sont reliées à des entrées des moyens de mesure qui peuvent être des entrées flottantes ou comprenant une borne à la masse.

Typiquement, la propriété électrique est une résistance. La résistance R1, R2, R3 ou R4 du matériau de la zone de séparation 160 mesurée entre les deux terminaisons centrales de même ligne continue correspondante 15, 16, 17 ou 18 varie fortement en fonction de l'éclairage de cette zone. Elle est inférieure ou égale à un seuil de conduction, de l'ordre de quelque Ohms dans le cas de l'AsGa semi-isolant pour des terminaisons centrales séparées par une distance de l'ordre de 5 micromètres, lorsque la zone de séparation est totalement éclairée par le faisceau de commande, depuis une des terminaisons centrale jusqu'à l'autre terminaison centrale de la ligne continue, elle est alors électriquement conductrice. La résistance du matériau de la zone de séparation, mesurée entre deux terminaisons centrales d'une même ligne, est supérieure ou égale à un seuil d'isolation de l'ordre de quelque MOhms dans le cas de l'AsGa semi-isolant, lorsque la zone de séparation n'est plus totalement éclairée, ou de façon plus générale, lorsque l'on décale la zone d'interaction de façon à ne plus éclairer totalement la partie de la zone de séparation 160 délimitée par les deux terminaisons centrales de cette ligne continue.

Les moyens de mesure 35, 36, 37, 38 d'une résistance électrique représentative d'un éclairement d'une zone de séparation 160 entre deux terminaisons centrales d'une même ligne continue comprennent par exemple un ohmmètre 35, 36, 37 ou 38 relié à des bornes de la ligne continue comme représenté sur la figure 3a.

En variante, on peut mesurer une autre grandeur que la résistance comme par exemple une tension au moyen d'un voltmètre, un courant au moyen d'un ampèremètre, une conductance.

La solution proposée est peu sensible aux variations de la fréquence de l'onde véhiculée par la ligne de transmission hyperfréquence 10. Elle perturbe peu le fonctionnement de la ligne hyperfréquence. La mesure de la propriété électrique peut être utilisée pour régler la position de la zone d'interaction ZI lorsque le commutateur est en configuration de fonctionnement, c'est-à-dire lorsqu'un signal est transmis sur la ligne hyperfréquence. La solution proposée ne nécessite pas forcément de banc de mesure hyperfréquence.

La solution proposée permet de limiter la durée et la complexité du réglage de la position de la zone d'interaction ZI par rapport à la zone active ZA et de la focalisation du faisceau optique sur le plan de la zone active par rapport à un réglage utilisant une valeur du coefficient de transmission moins précis et qui laisse des doutes sur le sens de la correction à apporter au positionnement relatif entre la fibre optique lentillée et la zone active ZA.

Les mesures des résistances permettent de contrôler le positionnement relatif entre la zone d'interaction et la zone active avec une grande précision inférieure au micromètre ce qui permet d'optimiser la puissance lumineuse transmise à la zone active ZA.

La valeur de la résistance peut aussi être utilisée pour contrôler le diamètre de la zone d'interaction ZI, c'est-à-dire la focalisation du faisceau optique de commande. En effet, la valeur de la résistance de la zone de séparation mesurée entre les deux terminaisons centrales d'une ligne continue est inférieure ou égale au seuil de conduction lorsque la zone d'interaction ZI recouvre entièrement la partie de la zone de séparation délimitée par les deux terminaisons centrales de la ligne continue. Dans cette configuration, la résistance diminue lorsque le diamètre de la zone d'interaction ZI augmente, car la densité d'énergie reçue diminue et augmente lorsque le diamètre de la zone d'interaction diminue jusqu'au seuil d'isolation lorsque la zone d'interaction ne s'étend plus continument de l'une à l'autre des terminaisons centrales de la ligne continue.

Les deux terminaisons centrales d'une même ligne continue sont disposées sur une droite dite droite d'alignement de la ligne continue.

Avantageusement, la droite d'alignement d'une ligne continue est sensiblement perpendiculaire au plan de séparation de la ligne continue. Dans l'exemple non limitatif des figures, les terminaisons centrales sont séparées par un même plan de séparation P. Par conséquent, les différentes droites d'alignement sont sensiblement parallèles entre elles. Elles sont parallèles à l'axe x dans cet exemple non limitatif. En variante, toutes les droites d'alignement ne sont pas parallèles entre elles. Autrement dit, les terminaisons centrales des différentes lignes continues peuvent être séparées par des plans de séparation différents.

Avantageusement, les deux terminaisons centrales d'au moins une ligne continue sont disposées sur une droite d'alignement perpendiculaire au plan de séparation P défini pour cette ligne continue, de façon symétrique l'une de l'autre par rapport à ce plan de séparation P. Ainsi, le dispositif de mesure de la résistance du matériau formant la zone de séparation 160, prise entre les deux terminaisons centrales, est simple. Dans l'exemple particulier de réalisation des figures 2a à 3b, les terminaisons centrales 153 et 154 ; 163 et 164 ; 173 et 174 et 183 et 184 des deux électrodes 151 et 152 ; 161 et 162 ; 171 et 172 et 181 et 182 d'une même ligne continue 15, 16, 17, et 18 sont situées sur un même cercle C1 ou C2 concentriques dont le centre est situé sur un même axe perpendiculaire au plan de la zone active ZA que le centre O. En variante, les terminaisons centrales des deux électrodes d d'une même ligne continue sont disposées à des distances différentes du plan P.

Sur la réalisation particulière des figures 2a à 3b, le dispositif de commutation comprend deux sous-ensembles, appelés E1 et E2 de lignes continues comprenant chacun deux lignes continues 15, 16 et 17, 18. Mais au moins un des sous-ensembles pourrait en variante comprendre une seule ligne continue ou plus de deux lignes continues.

Les terminaisons centrales des électrodes des lignes de deux sous-ensembles E1 et E2 sont disposées sur des cercles C1 et C2 concentriques de diamètres D1 et D2 différents (D2 étant supérieur à D1), les terminaisons centrales 153, 163, 173, 183 du premier sous-ensemble sont disposées sur le premier cercle C1 et les terminaisons centrales 154, 164, 174, 184 du deuxième sous-ensemble sont disposées sur le deuxième cercle C2.

Cet agencement particulier des terminaisons centrales sur des cercles concentriques de différentes diamètres permet de déterminer automatiquement et rapidement, uniquement à partir des mesures de résistances (ou autres propriétés électriques) des lignes continues, le sens de réglage de la focalisation pour rapprocher le plan focal de la zone active ZA pour tout diamètre initial de la zone d'interaction ZI tel que le faisceau optique de commande FO éclaire la zone de séparation.

Avantageusement, les terminaisons centrales 153, 154, 163, 164, 173, 174, 183 et 184 des lignes continues sont disposées à des distances du centre O, prises dans un plan perpendiculaires au plan de la zone active ZA, supérieures aux distances séparant les terminaisons 11a et 12a des pistes 11 et 12 qui délimitent la zone active ZA. Autrement dit, les terminaisons centrales 153, 154, 163, 164, 173, 174, 183 et 184 sont situées à l'extérieur de la zone active ZA. Cela permet de limiter une perturbation de la ligne de transmission par les lignes continues et inversement.

De préférence, les terminaisons centrales 153, 154, 163, 164, 173, 174, 183 et 184 des électrodes des lignes continues 15 à 17 sont disposées à des distances du centre O, prises dans un plan perpendiculaires à la zone active, supérieures au rayon optimal RO de la zone d'interaction ZI lorsque la zone d'interaction ZI est centrée sur le centre O et est focalisée sur la zone active ZA. Cela permet aussi de limiter une perturbation de la ligne de transmission par les lignes continues ou des lignes continues par la ligne de transmission. On limite ainsi les perturbations de la ligne hyperfréquence et du fonctionnement du dispositif de commutation dans sa fonction de commutation.

Lorsqu'initialement, le diamètre D de la zone d'interaction est supérieur à D1 et D2, la zone d'interaction ZI étant sensiblement centrée en x et z, alors R1, R2, R3 et R4 sont du même ordre de grandeur, c'est à dire inférieures ou égales au seuil de conduction, on peut détecter que le sens de réglage de la focalisation est le sens de défocalisation du faisceau (le plan focal s'éloigne du plan de la zone active), lorsqu'au moins une des conditions de défocalisation suivante est vérifiée : les résistances augmentent tout en restant du même ordre de grandeur, c'est-à-dire inférieures ou égales au seuil de conduction du fait de la diminution de la densité lumineuse éclairant la zone de séparation 160 lorsque la taille de la zone d'interaction ZI augmente et/ou, dans la configuration coplanaire, les résistances diminuent jusqu'à une valeur sensiblement nulle lorsque le diamètre D de la zone d'interaction ZI augmente jusqu'à ce que le faisceau optique FO vienne éclairer les plans de masse et court-circuiter les lignes continues. Lorsqu'une condition de défocalisation est vérifiée, le sens de réglage de la focalisation est alors avantageusement inversé.

Si initialement, D est compris entre D1 et D2, la zone d'interaction ZI étant sensiblement centrée en x et z, alors R3 et R4 sont supérieures au seuil d'isolation et R1 et R2 sont inférieures ou égales au seuil de conduction. Autrement dit, R3 et R4 sont très supérieures à R1 et R2. Dans cette configuration, on peut détecter que le sens de réglage de la focalisation du faisceau est celui de la défocalisation lorsqu'au moins une des conditions de défocalisation suivante est vérifiée : R1 et R2 diminuent ou R3 et R4 deviennent inférieures au seuil de conduction (D est alors supérieur à D1 et supérieur ou égal à D2) ou le rapport de R1 ou R2 sur R3 ou R4 devient inférieur à un rapport seuil prédéterminé. A l'inverse, si R1 et R2 augmentent, le sens du réglage de la focalisation est celui de la focalisation (le plan focal se rapproche du plan de la zone active). R1 et R2 vont augmenter jusqu'à atteindre le seuil d'isolation lorsque D devient inférieur à D1 et jusqu'à atteindre un seuil de non éclairage lorsque la zone de séparation 160 n'est plus éclairée. Le rayon de la zone d'interaction ZI est alors le rayon optimal RO de la zone d'interaction ZI.

Si initialement, la zone d'interaction ZI est sensiblement centrée en x et z, et D inférieur à D1, alors les résistances R1, R2, R3 et R4 sont supérieures au seuil d'isolation ce qui permet de savoir que l'on est proche du maximum du coefficient de transmission sur la ligne hyperfréquence et donc de la focalisation sur la zone active. Le sens de la focalisation du faisceau peut être obtenu par une mesure du coefficient de transmission de la ligne de transmission 10 au travers du dispositif de commutation lors d'un déplacement de la fibre optique lentillée 21 selon l'axe y ou de la variation de ce coefficient. Ce sens de déplacement est celui de l'augmentation du coefficient de transmission vers un maximum. La focalisation est par exemple détectée lorsque le coefficient de transmission est maximal. Le réglage de la focalisation est par exemple stoppé lorsque la condition de focalisation est vérifiée. Le signal hyperfréquence peut être le signal hyperfréquence utile destiné à être transmis sur la ligne hyperfréquence, par exemple destiné à être échantillonné, ou un signal hyperfréquence de calibration superposé au signal utile et étant séparable du signal utile. A cet effet, il est par exemple formé dans une ou plusieurs fréquences séparable(s) du spectre du signal utile.

En variante, la focalisation est vérifiée lorsque les résistances R1 et R2 atteignent un seuil de non éclairage prédéterminé.

Par ailleurs, le sens du déplacement correct de la fibre optique lentillée selon l'axe x est défini aisément lorsque D est compris entre D1 et D2. En effet si la zone d'interaction ZI est initialement centrée en x, en déplaçant la zone d'interaction ZI vers la droite selon l'axe x, R1 et R2 augmentent rapidement jusqu'au seuil d'isolation alors que R3 et R4 restent supérieures au seuil d'isolation. Si l'on continue de s'éloigner de cette position selon x, R1 et R2 restent supérieures au seuil d'isolation. Lorsque la zone d'interaction ZI est initialement très décentrée en x, lorsque l'on se déplace dans le sens du centrage en x, R1 à R4 restent d'abord sensiblement fixes et supérieures au seuil d'isolation. Ensuite R1 et R2 diminuent rapidement jusqu'au seuil de conduction lorsque que la zone d'interaction ZI vient recouvrir les terminaisons centrales des lignes 16 et 17 puis R3 et R4 diminuent rapidement jusqu'au seuil de conduction lorsque la zone d'interaction ZI vient recouvrir les terminaisons centrales des lignes 18 et 19.

Dans le mode particulier de réalisation des figures 2a à 3b, chacun des deux sous-ensembles E1 et E2 de lignes de courant continu comprend deux lignes de courant continu 15 et 16 pour E1 et 17 et 18 pour E2. Les terminaisons centrales des électrodes des deux lignes continues respectives d'un même sous-ensemble sont disposées de deux côtés respectifs d'un même plan P' perpendiculaire au plan P et à la zone active ZA et passant par O. Autrement dit, les terminaisons centrales163 et 164 des électrodes de la ligne 16 sont disposées de l'autre côté du plan P' par rapport aux terminaisons centrales 153 et 154 des électrodes de la ligne 15. Il en est de même pour les terminaisons des lignes 17 et 18. De façon générale, au moins un des sous-ensembles comprend avantageusement deux lignes continues agencées de cette manière. Cette disposition permet de régler la position de la zone d'interaction ZI selon l'axe z à partir de mesures des résistances R1 et R2 et/ou R3 et R4, par exemple en comparant des mesures de R1 et R2 et/ou des variations de R1 et R2 et/ou des mesures de R3 et R4 et/ou des variations de R3 et R4.

Avantageusement, les terminaisons centrales des électrodes des deux lignes du même sous-ensemble sont disposées de façon symétrique les unes des autres par rapport au plan P'. Ainsi, les résistances des deux lignes du même sous-ensemble sont sensiblement égales lorsque le diamètre D de la zone d'interaction ZI est supérieur ou égal à D1 et est centrée en z. Ainsi, dans la réalisation des figures, R1 = R2 lorsque la zone d'interaction ZI est centrée en z et recouvre les terminaisons centrales des lignes 15 et 16 et R3 = R4 lorsque la zone d'interaction ZI est centrée en z et recouvre les terminaisons centrales des lignes 17 et 18. La présence des deux sous-ensembles permet d'obtenir une double vérification du centrage en z. La condition de centrage en z peut être R1 = R2 et/ou R3 = R4.

Lorsque l'on décentre la zone d'interaction ZI en z vers le haut, avec D supérieur à D1 et la zone d'interaction ZI étant centrée en x, alors R2 et R4 viennent dépasser le seuil d'isolation et R1 reste inférieure ou égale au seuil de conduction jusqu'à un certain décentrage, avant d'augmenter rapidement de façon significative si le décentrage en z dépasse le seuil. Si D est supérieur à D2, alors R4 subit la même variation que R2 et augmente rapidement après R2).

La présence des deux lignes pour un même sous-ensemble permet d'avoir une double vérification pour le réglage du centrage de la zone d'interaction en x.

On peut prévoir au moins une ligne continue d'un premier type, dont une des terminaisons centrale est disposée d'un côté du plan de séparation P et dont l'autre terminaison est disposée de l'autre côté du plan de séparation P, les deux terminaisons centrales étant disposées sur une droite d'alignement perpendiculaire au plan de séparation P et au moins une ligne continue d'un deuxième type dont une des terminaisons centrales est disposée d'un côté du plan P' et l'autre est disposée de l'autre côté du plan P' (P' est alors le plan de séparation pour cette ligne du deuxième type), les deux terminaisons étant disposées sur une droite perpendiculaire à P'. Cette disposition permet de contrôler la position de la zone d'interaction ZI selon les axes x et z. Le dispositif peut comprendre deux lignes continues du deuxième type dont les terminaisons centrales d'une des lignes du deuxième type sont disposées d'un côté du plan P et dont les terminaisons centrales de l'autre ligne du deuxième type sont disposées de l'autre côté du plan P. Avantageusement, mais non nécessairement, les terminaisons de ces deux lignes sont disposées de façon symétrique par rapport au plan P. En variante, les terminaisons d'une ligne continue du deuxième type sont disposée sur le plan P, autrement dit, elles sont diamétralement opposées. Chacune de ces lignes continues du deuxième type peut appartenir à un même sous-ensemble qu'une ligne continue du premier type ou à un autre sous-ensemble.

La figure 3b représente schématiquement une coupe du commutateur de la figure 3a selon l'axe BB'. Comme visible sur cette figure, les électrodes 171, 172 sont déposées sur le substrat 13, 14 et plus particulièrement sur la couche 14.

Avantageusement, la zone active ZA et la zone de séparation 160 sont réalisées dans des matériaux différents. Cette configuration permet, par une isolation des porteurs photogénérés dans les deux zones, de limiter les perturbations des lignes de mesure et de transmission l'une sur l'autre. Le réglage du positionnement peut être fait lorsque le dispositif de commutation fonctionne c'est-à-dire lors de son utilisation en tant que commutateur. A cet effet, dans la réalisation non limitative des figures, les électrodes des lignes continues sont disposées sur la première couche 13 du substrat, comme visible sur la figure 3b, alors que les pistes conductrices de la ligne hyperfréquence 10 sont disposées sur la deuxième couche 14 comme visible sur la figure 2b.

Avantageusement, les porteurs de la zone active ZA présentent une durée de vie plus courte que les porteurs de la zone de séparation 160. Cette caractéristique permet d'obtenir une mesure plus précise de la résistance de la zone de séparation 160 que si la zone de séparation présente des porteurs de durée de vie plus faible tout en obtenant un bon coefficient de transmission sur la ligne hyperfréquence.

L'invention se rapporte également à un procédé de fabrication du dispositif de commutation selon l'invention comprenant une étape de fabrication du commutateur selon l'invention comprenant les étapes de former les pistes conductrices de façon qu'elles soient séparées parle gap assurant une isolation électrique entre les pistes et de façon à délimiter la zone active, et l'étape de disposer les électrodes d'au moins une ligne continue sur le substrat de façon qu'elles soient distantes l'une de l'autre, reliées par la zone de séparation et séparées par un plan P de séparation passant par le centre O et perpendiculaire à la zone active ZA. Autrement dit, la première terminaison centrale d'une ligne continue est disposée d'un côté du plan de séparation P et la deuxième terminaison de la même ligne est disposée de l'autre côté du plan de séparation P de cette ligne. Les électrodes et les pistes conductrices sont formées sur un substrat.

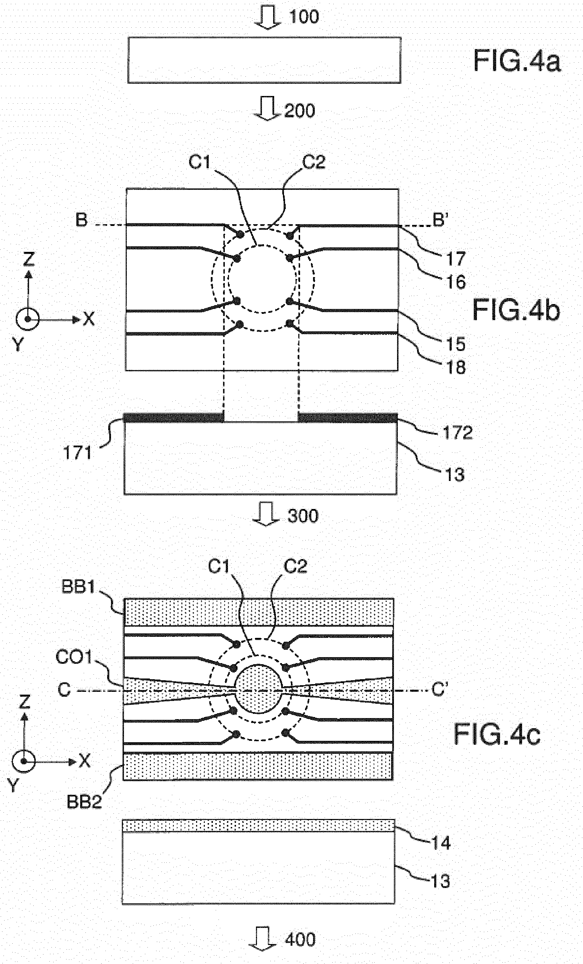

Ce procédé comprend avantageusement les étapes suivantes représentées sur les figures 4a à 4c :
- Prévoir 100 la première couche 13 du substrat SUB (figure 3a),
- Disposer 200 des électrodes d'au moins une ligne continue sur la première couche du substrat 13 de sorte qu'elles soient reliées par une zone de la première couche 13 formant la zone de séparation (figure 4b en vue de dessus et en vue en coupe BB'),
- Disposer 300 la deuxième couche 14 du substrat, sur le premier substrat 13, la deuxième couche 14 comprenant une première couche continue CO1 comprenant des zones destinées à recevoir les pistes conductrice 11 et 12 reliées par une zone destinée à former la zone active ZA (figure 4c en vue de dessus et en vue en coupe selon CC'),
- Disposer 400 les pistes conductrices 11 et 12 sur les zones destinées à recevoir les pistes conductrices de sorte à obtenir le commutateur représenté sur les figures 2a à 3b.

L'étape de formation 300 de la deuxième couche 14 comprend, sur l'exemple coplanaire de la figure 4c, une étape de formation des deux autres bandes BB1 et BB2 destinées à recevoir les bandes conductrices. Le procédé comprend alors une étape de formation, sur ces bandes, des bandes conductrices B1 et B2 destinées à former les plans de masse.

L'étape 200 de disposition des électrodes peut être précédée d'une étape de gravure locale de matériau photosensible qui prédéfinit spatialement la position optimale circulaire de la zone d'interaction de taille optimale et éventuellement celle des électrodes. Dans l'exemple des figures, le matériau photosensible est le matériau de la couche 13.

La formation de la deuxième couche 14 est avantageusement mise en œuvre après masquage des zones des électrodes des lignes continues sans masquer les zones destinées à recevoir la deuxième couche 14.

Les deux bandes conductrices et de la couche continue présentent, de préférence, sensiblement la même épaisseur.

Sur la figure 5, on a représenté schématiquement les éléments du dispositif de commutation selon l'invention.

Le dispositif de commutation comprend des moyens de réglage 30R permettant de régler la position de la zone d'interaction ZI par rapport à la zone active, dans le plan de la zone active ZA, au moins selon la direction x, et de préférence selon la direction y, et/ou le diamètre de la zone d'interaction ZI, c'est-à-dire la focalisation du faisceau optique de commande, à partir d'au moins une mesure MES, 30M de la valeur d'une propriété électrique délivrée des moyens de mesure ou à partir d'une pluralité de mesures d'au moins une propriété électrique délivrée par les moyens de mesure. Cela permet une automatisation au moins partielle du réglage de la focalisation du faisceau optique sur la zone active ZA et/ou de l'alignement de la zone d'interaction ZI par rapport à la zone active ZA, dans le plan de la zone active.

Le dispositif de réglage 30R peut aussi utiliser, pour ces réglages, des mesures d'un coefficient de transmission d'un signal hyperfréquence délivré par des moyens de mesure 30C du coefficient de transmission d'un signal hyperfréquence, par exemple de calibration, sur la ligne hyperfréquence au travers du commutateur, comme représenté sur la figure 5. Ces moyens peuvent par exemple comprendre des moyens de mesure de la puissance du signal hyperfréquence de calibration en entrée et en sortie du commutateur.

Les figures 6a et 6b représente schématiquement deux vues d'une partie du dispositif de commutation selon l'invention. Les lignes continues ne sont pas représentées pour plus de clarté. Le dispositif de commutation comprend le commutateur COM et des moyens d'acheminement 19 permettant de confiner le faisceau optique de commande FO et de l'acheminer jusqu'à la zone active ZA. Les moyens d'acheminement 19 comprennent au moins un composant optique au travers duquel passe le faisceau optique entre la source 23 représenté sur la figure 5 du faisceau et la zone d'interaction ZI. Les moyens d'acheminement 19 comprennent par exemple fibre optique 21 permettant de guider le faisceau optique de commande et/ou une lentille de focalisation 22 permettant de focaliser le faisceau. Ces moyens d'acheminement 19 permettent de limiter la taille de la zone d'interaction ZI. En variante, le dispositif de commutation est dépourvu de moyens d'acheminement. Dans l'exemple non limitatif des figures, les moyens d'acheminement comprennent une fibre optique lentillée comprenant une fibre optique 21 munie d'une lentille de focalisation 22 fixée à une extrémité de la fibre optique 21. L'invention est décrite en référence à cet exemple mais s'applique à tout type de moyens d'acheminement.

En déplaçant un composant optique ou une partie d'un composant optique des moyens d'acheminement 19 et/ou la source 23 par à la zone active ZA ou par rapport au centre O, on déplace la zone d'interaction ZI par rapport à la zone active ZA ou par rapport au centre O dans le plan de la zone active ZA et/ou on modifie le diamètre de la zone d'interaction ZI. Les moyens de réglage permettent donc avantageusement de régler la position d'au moins un composant optique ou d'une partie d'au moins un composant optique des moyens d'acheminement 19 et/ou la source 23 par rapport la zone active ZA de sorte à régler la focalisation du faisceau optique par rapport au plan de la zone active et/ou la position de la zone d'interaction ZI dans le plan de la zone active ZA.

Dans la réalisation non limitative des figures 6a et 6b, la fibre optique lentillée 21, est une fibre optique munie d'une lentille 22 de focalisation solidaire d'une extrémité 21A de la fibre optique 21. En rapprochant/éloignant cette extrémité 21A de la fibre optique de la zone active ZA selon l'axe y, le diamètre de la zone d'interaction ZI augmente / respectivement diminue. En déplaçant cette extrémité selon l'axe x, respectivement z, on déplace la zone d'interaction ZI par rapport à la zone active ZA ou par rapport au centre O, selon l'axe x, respectivement selon l'axe z.

La solution proposée permet, grâce aux moyens de réglage, d'effectuer les réglages d'alignement et de focalisation pendant toute la durée de vie du dispositif de commutation ce qui est avantageux lorsque le dispositif de commutation est soumis à des vibrations pouvant induire des déplacements relatifs entre l'extrémité 21A de la fibre optique lentillée 19 et la zone active ZA car elle permet de limiter les pertes de transmission sur la ligne de transmission et d'éviter d'avoir à faire fortement diverger le faisceau en sortie de fibre pour assurer l'illumination de la zone active ZA ou d'avoir à utiliser des lasers puissants assez difficilement commandables à des fréquences élevées avec un bon contraste de puissance. La solution proposée permet donc d'envisager une diminution de la puissance optique à fournir à la fibre optique.

Avantageusement, les moyens de réglage 30R sont configurés de sorte à permettre de faire les réglages lorsque le dispositif de commutation est en configuration opérationnelle, c'est-à-dire lors de son utilisation en tant que commutateur.

Avantageusement, les moyens de réglage 30R permettent de régler la position relative la source 23 et/ou au moins une partie d'au moins un composant optique des moyens d'acheminement (l'extrémité 21A dans l'exemple des figures) de façon indépendante selon plusieurs axes orthogonaux.

Les moyens de réglage 30R comprennent un organe de commande OCOM, 31R configuré pour générer un déplacement relatif de commande, à partir d'au moins une mesure d'une propriété électrique réalisée par les moyens de mesure ou à partir de plusieurs mesures d'une propriété électrique réalisées, par les moyens de mesure, pour plusieurs positions relatives entre la zone active ZA et la source 23 et/ou au moins une partie d'au moins un composant optique des moyens d'acheminement (l'extrémité 21A dans l'exemple des figures) par rapport à la zone active selon au moins une direction.

Les moyens de réglage 30R comprennent également un dispositif d'actionnement 32R comprenant au moins un actionneur permettant de déplacer la source 23 et/ou au moins une partie d'au moins un composant optique des moyens d'acheminement (l'extrémité 21A dans l'exemple des figures) par rapport à la zone active ZA, selon au moins une direction (au moins la direction x ou y), mais de préférence selon les trois directions, sur réception du déplacement relatif de commande. Le dispositif d'actionnement est avantageusement configuré pour déplacer la source 23 et/ou au moins une partie d'au moins un composant optique des moyens d'acheminement par rapport à la zone active, du déplacement relatif de commande généré par l'organe de commande et reçus par le dispositif d'actionnement. Le ou les actionneur(s) sont de préférence à commande électrique de façon à permettre de réaliser un réglage automatique. En variante ou en sus, les actionneurs sont à commande manuel.

Avantageusement, le dispositif d'actionnement 32R est fixé au commutateur COM.

Comme visible sur la figure 5, le dispositif d'actionnement 32R comprend par exemple un support intermédiaire 102 déformable et un ensemble 101 d'au moins un actionneur.

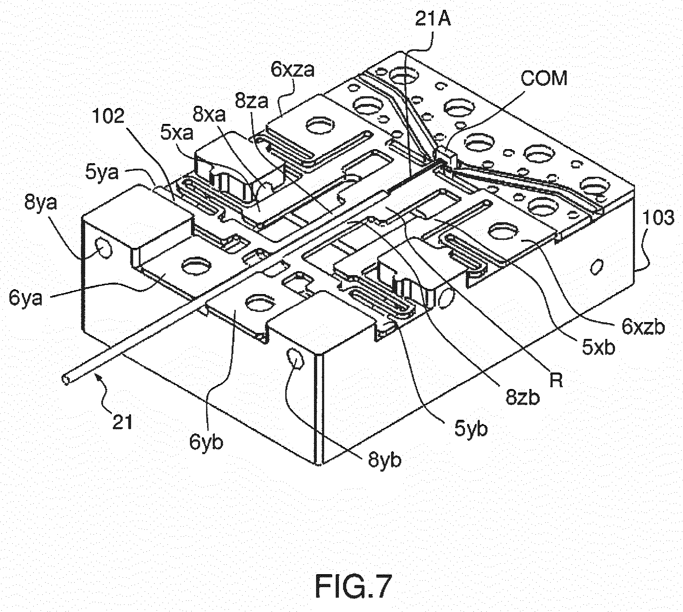

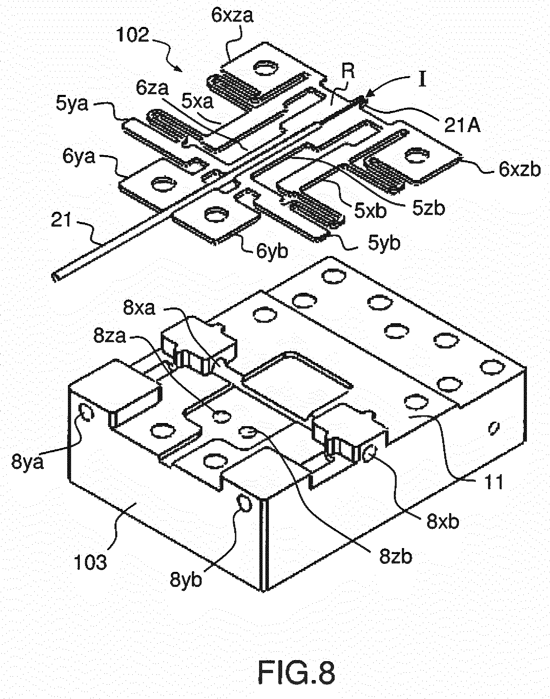

Le support intermédiaire déformable 102 est représenté plus précisément sur les figures 7 à 10.

Le support intermédiaire comprend réceptacle R recevant la fibre optique 21 et comprenant une zone d'intérêt I solidaire de l'extrémité de la fibre optique lentillée (ou tout élément à déplacer par rapport à la zone active pour les réglages). Le réceptacle R comprend par exemple un sillon SI recevant l'extrémité de la fibre optique et configuré pour maintenir l'extrémité de la fibre optique soit fixe par rapport à lui. Le support intermédiaire 102 déformable est disposé sur un support commun 103 sur lequel est aussi disposé le commutateur COM. La fibre optique 21 est disposée sur le support intermédiaire.

Le dispositif d'actionnement comprend des actionneurs 8xa, 8xb, 8ya, 8yb, 8za, 8zb configurés pour déformer le support, de préférence de façon élastique, de sorte à déplacer la zone remarquable I par rapport à la zone active ZA de façon à déplacer l'extrémité de la fibre optique par rapport à cette zone active.

Avantageusement, le support intermédiaire 102 déformable est monobloc 2. Par support intermédiaire monobloc, on entend un support constitué d'une seule pièce ou d'une pluralité de pièces assemblées de façon solidaire les unes aux autres. Un support monobloc peut être formé par un assemblage composite de matériaux différents.

Le support intermédiaire 2 comprend des zones d'ancrage 6xza, 6xzb ; 6ya, 6yb ; 6xza, 6xzb fixes par rapport à la zone active.

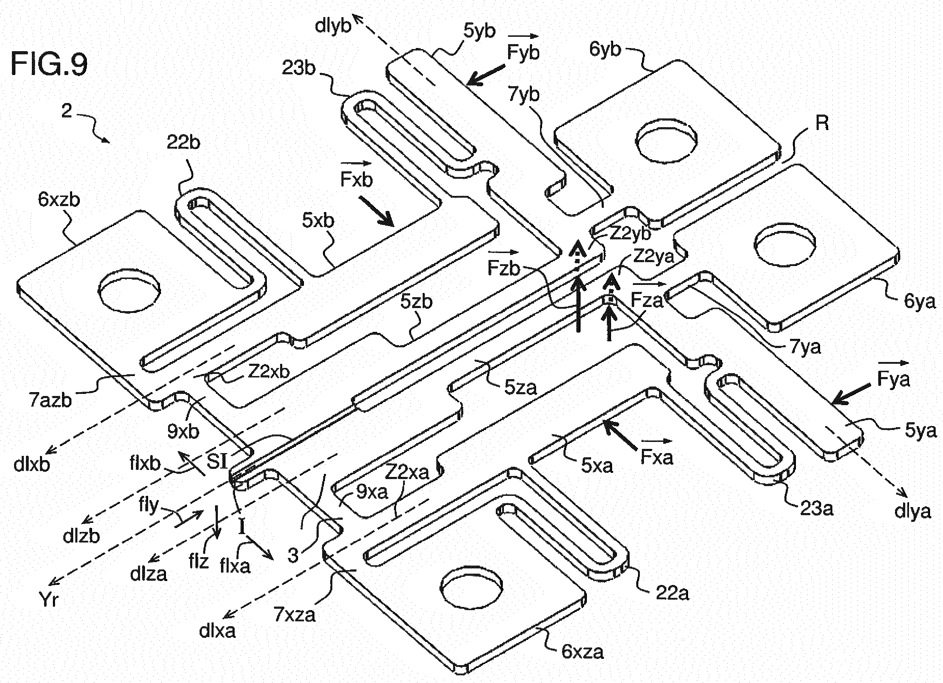

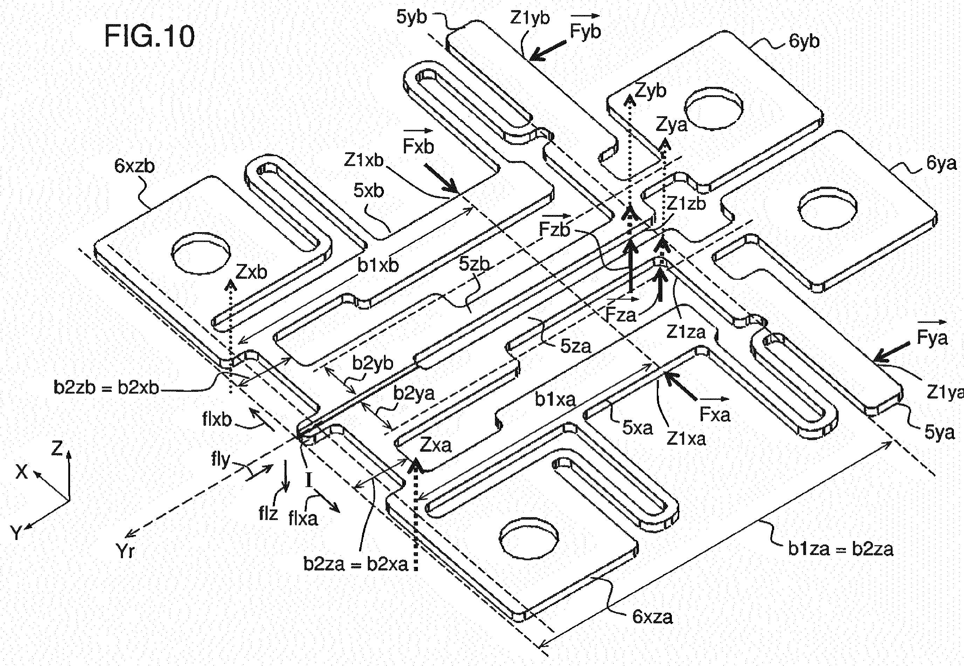

Le dispositif de réglage comprend plusieurs sous-ensembles de réglage destiné à régler la position de la zone remarquable I par rapport à la zone active ZA. Chaque sous-ensemble de réglage comprend, par exemple, deux leviers 5xa, 5xb ; 5ya, 5yb ; 5za, 5zb formés dans le support intermédiaire 2 et étant chacun reliés à une des zone d'ancrage fixes 6xza, 6xzb ; 6ya, 6yb ; 6xza, 6xzb (au moyen d'une zone charnière souple 7xza, 7xzb ; 7ya, 7yb ; 7xza, 7xzb) et au moins un actionneur 8xa, 8xb ; 8ya, 8yb ; 8za, 8zb destiné à exercer un effort Fxa, Fxb ; Fya, Fyb ; Fza Fzb (figures 9 et 10), sur une première zone Z1xa, Z1xb ; Z1ya, Z1yb ; Z1za, Z1zb de chaque bras levier 5xa, 5xb ; 5ya, 5yb ; 5za, 5zb avec un premier bras de levier b1xa, b1xb ; b1ya, b1yb ; b1za, b1zb mesuré le long dudit levier 5xa, 5xb ; 5ya, 5yb ; 5za, 5zb par rapport à ladite zone charnière souple 7xza, 7xzb ; 7ya, 7yb ; 7xza, 7xzb ledit effort Fxa, Fxb ; Fya, Fyb ; Fza, Fzb permettant de faire pivoter le levier 5xa, 5xb ; 5ya, 5yb ; 5za, 5zb par rapport à ladite zone d'ancrage 6xza, 6xzb ; 6ya, 6yb ; 6xza, 6xzb autour de la zone charnière souple 7xza, 7xzb ; 7ya, 7yb ; 7xza, 7xzb ladite zone remarquable I du réceptacle 3 étant reliée à une deuxième zone du levier Z2xa, Z2xb ; Z2ya, Z2yb ; 30 avec un deuxième bras de levier b2xza, b2xzb ; b2ya, b2yb ; b2xza, b2xzb (figure 10) mesuré le long dudit levier 5xa, 5xb ; 5ya, 5yb ; 5za, 5zb par rapport à la zone charnière souple 7xza, 7xzb ; 7ya, 7yb ; 7xza, 7xzb, ledit deuxième bras de levier étant inférieur au premier bras de levier b1xa, b1xb ; b1ya, b1yb ; b1za, b1zb, de sorte que le levier 6xza, 6xzb ; 6ya, 6yb ; 6xza, 6xzb assure, sous l'effet de l'effort Fxa, Fxb ; Fya Fyb ; Fza, Fzb, une transmission, à la zone remarquable 30, d'un mouvement de la première zone Z1xa, Z1xb ; Z1ya, Z1yb ; Z1za, Z1zb du levier 5xa, 5xb ; 5ya, 5yb ; 5za, 5zb selon la x, y, z de réglage, ledit mouvement de la première zone du levier Z1xa, Z1xb ; Z1ya, Z1yb ; Z1za, Z1zb étant transmis de façon démultipliée à la zone remarquable I. Sur la réalisation des figures, la zone remarquable I correspond à une extrémité des leviers 5za et 5zb.

Le dispositif de réglage permet de régler la position de la zone remarquable par rapport à la zone active selon trois directions de réglage x, y et z orthogonales respectives de façon indépendante au moyen de sous-ensembles de réglage respectifs. Les efforts respectifs Fxa, Fxb ; Fya Fyb et Fza, Fzb selon les directions respectives x, y et z respectifs provoquent des translations des premières zones respectives Z1xa, Z1xb ; Z1ya, Z1yb ; Z1za, Z1zb des leviers respectifs 5xa, 5xb ; 5ya, 5yb ; 5za, 5zb selon les directions de réglage respectives x ; y et z.

Le support intermédiaire 2 est représenté au repos sur les figures. Sous l'effet des efforts Fxa et Fxb sensiblement parallèles à la direction x, les zones charnières souples 7xza et 7xzb reliant les leviers respectifs 5xa et 5xb aux zones d'ancrage respectives 6xa et 6xb se cintrent faisant pivoter ces leviers 5xa, 5xb par rapport aux zones d'ancrage respectives 6xa et 6xb autour des zones charnières souples respectives 7xza, 7xzb ce qui correspond sensiblement à des pivotements des premiers leviers 5xa et 5xb autour d'axes respectifs Zxa et Zxb (placés de façon approximative sur les figures) par rapport au support 1.

Des flèches fixa, flxb, fly et flz représentent les directions et sens des mouvements principaux de la zone remarquable I engendrés par les efforts respectifs Fxa, Fxb, Fya et Fyb ; Fza et Fzb appliqués sur les leviers respectifs 5xa, 5xb, 5ya, 5yb, 5za, 5zb. Les leviers 5xa et 5xb s'étendent longitudinalement, au repos, parallèlement à l'axe y. Les actionneurs respectifs associés aux leviers respectifs 5xa et 5xb sont configurés pour exercer, sur ces leviers 5xa respectifs 5xb, des efforts respectifs Fxa et Fxb sensiblement parallèles à x et qui génèrent des mouvements des premières zones des leviers Z1xa, Z1xb. Ces mouvements sont sensiblement des mouvements de translation selon l'axe x.

Le support est configuré pour que le mouvement de la première zone du levier selon la direction x soit transmis à la zone remarquable 30. A cet effet, les leviers 5xa, 5xb sont reliés au réceptacle 2 avec les deuxièmes bras de levier respectifs b2xa, b2xb au moyen de barres d'effort respectives 9xa, 9xb. Par conséquent, lorsque la zone Z1xa, Z1xb d'un levier 5xa, 5xb est animée d'un mouvement de translation selon x sous l'effet de l'effort Fxa, Fxb, la zone remarquable 30 est animée d'un mouvement de translation selon x dans le sens représenté par la flèche fixa, flxb. Les rapports entre les déplacements de la zone remarquable 30 et ceux des zones Z1xa, Z1xb sont égaux aux rapports entre les premiers bras de leviers respectifs b1xa et b1xb et les deuxièmes bras de levier respectifs b2xa et b2xb dans le cas où les leviers ne se déforment pas sous l'effet des efforts respectifs Fxa, Fxb. Autrement dit, le mouvement principal de la première zone Z1xa Z1xb, d'un premier levier 5xa, 5xb est transmis de façon démultipliée à la zone remarquable I par effet de levier. Le principe de réglage du mouvement est le même pour chaque sous-ensemble de réglage et ne sera pas décrit à nouveau.

L'absence de jeu permet d'atteindre précision de positionnement de l'extrémité de la fibre inférieure ou égale 1 µm dans l'espace voisin de la zone active ce qui permet donc de diriger la quasi-intégralité de l'énergie lumineuse du faisceau optique émis par la fibre sur le photo-commutateur, lui conférant alors d'excellentes performances en termes de contraste tout en évitant l'utilisation de sources laser puissantes. Ainsi, le dispositif selon l'invention permet de réaliser un dispositif d'échantillonnage Radiofréquence (RF) à haut rendement sans dégrader de façon notable le signal d'entrée. Ainsi la réalisation de fréquencemètre par analyse de Fourier est accessible, non seulement en amplitude mais aussi en phase permettant d'inclure les fonctions de mesures de la direction d'arrivée d'une onde à celles de caractérisations fréquentielles et temporelles d'un signal. L'absence de jeu permet également une très bonne maitrise du positionnement. Le rapport de démultiplication permet d'obtenir une précision inférieure au micromètre avec un actionneur moins précis qui est donc peu coûteux, par exemple une vis micrométrique.

Ce dispositif permet de réaliser un réglage réversible. Il est peu volumineux et peut assurer le réglage du positionnement relatif avant toute utilisation du dispositif ou pendant toute la durée de vie du dispositif. Il permet en effet de maintenir un des objets dans la position relative souhaitée en maintenant, au moyen des actionneurs, les efforts appropriés permettant d'obtenir la position souhaitée sur les leviers respectifs.

Les leviers 5ya, 5yb s'étendent longitudinalement selon l'axe x au repos et les leviers 5za, 5zb selon l'axe y.

Avantageusement, tous les leviers sont coplanaires au repos. Le support intermédiaire est donc compact et facile à réaliser. Avantageusement, le support intermédiaire 102 est sensiblement plan au repos.

Avantageusement, les leviers associés aux différentes directions principales de réglage sont distincts pour assurer un découplage du réglage selon les trois directions orthogonales.

Les actionneurs respectifs 8xa, 8xb ; 8ya, 8yb ; 8za, 8zb peuvent comprendre chacun un élément destiné à venir en appui sur un levier de manière à appliquer l'effort sur ledit levier. L'élément peut être un actionneur piézoélectrique ou une vis, par exemple une vis pointeau, du type à pas inférieur à 1 mm ou au moins égal à 1 millimètre s'étendant en regard des leviers respectifs et destinées à venir en appui sur les leviers respectifs de manière à appliquer les efforts respectifs sur ces leviers. En variante, les actionneurs sont du type permettant d'appliquer à distance les efforts respectifs sur les leviers respectifs. Un tel actionneur comprend par exemple un dispositif de commande électrique permettant d'appliquer une tension variable aux bornes d'une bobine produisant un champ magnétique variable dont l'effet de la variation déplace la première zone du levier correspondant.

Avantageusement, au moins un levier, et de préférence tous les leviers sont conçus pour se déformer élastiquement en flexion sous l'effet de l'effort correspondant (Fxa) ce qui contribue à la démultiplication du mouvement entre la première zone du levier et la zone remarquable. La démultiplication mécanique obtenue par l'effet levier est ainsi accrue par la déformation élastique du levier lui-même sous l'effet de l'effort car le levier s'oppose en quelque sorte au pivotement

En variante, au moins un levier est rigide dans le sens où il ne se déforme pas sous l'effet des efforts.

Sur la réalisation non limitative des figures, le dispositif de réglage comprend six sous-ensembles de réglage destinés à régler la position de la zone remarquable I selon trois directions principales de réglage orthogonales x, y et z, dont deux sous-ensembles par direction principale de réglage. En variante, le nombre de sous-ensembles de réglage est différent de 6 et/ou le nombre de levier par sous-ensemble est différent.

Le réceptacle R comprend des éléments de maintien 22a, 22b, 23a, 23b, référencés sur la figure 9, permettant de maintenir chaque levier dans une position de repos lorsque les efforts sont nuls. Ces moyens comprennent, sur la réalisation des figures, des premiers éléments 22a, 22b ressort reliant les premières zones d'ancrage 6xza, 6xzb et les premiers leviers 5xa, 5xb respectifs et des deuxièmes éléments ressorts 23a, 23b reliant les premiers leviers 5xa, 5xb et les deuxièmes leviers 5ya, 5yb respectifs. Les éléments de maintien présentent une raideur inférieure à la raideur des zones charnière souples 7xza, 7xzb reliant les leviers correspondants (ici les premiers leviers 5xa, 5xb) et les zones d'ancrage correspondantes 6xza, 6xzb.

Comme visible sur la figure 6a, les deux pistes 11 et 12 de la ligne de transmission sont alignées et s'étendent longitudinalement selon l'axe x parallèle aux droites sur lesquelles sont disposées les terminaisons des différentes lignes continues.

Avantageusement, le support intermédiaire 102 ainsi qu'une face plane du commutateur perpendiculaire à la zone active ZA sont disposées sur une même face plane ou des faces planes parallèles du support commun ce qui permet de faciliter le réglage du positionnement de l'extrémité de la fibre optique par rapport à la zone active.

L'invention se rapporte également à un procédé d'alignement de la source et/ou d'au moins une partie d'au moins un composant optique des moyens d'acheminement par rapport à la zone active de façon à obtenir une position prédéterminée de la zone d'intérêt par rapport à la zone active dans le plan de la zone active et/ou de façon à focaliser le faisceau optique sensiblement sur le plan de la zone active, ledit procédé comprenant les étapes suivantes :
- mesurer la propriété électrique de la zone de séparation entre les terminaisons d'au moins une ligne pour véhiculer un courant continu dudit ensemble,
- régler la position de la source et/ou d'au moins une partie d'au moins un composant optique des moyens d'acheminement relativement au dispositif de commutation à partir de ladite mesure.

La position relative peut aussi être réglée à partir d'une mesure du coefficient de transmission comme décrit précédemment.

Le réglage est avantageusement réalisé à partir de plusieurs mesures de la propriété électrique obtenues pour plusieurs positions relatives connues.

Le réglage peut comprendre une étape de calcul d'une variation de la propriété électrique, à partir des mesures et/ou une étape de comparaison d'une mesure de la propriété électrique à un seuil (par exemple au seuil de conduction ou d'isolation).

Dans le cas où on a plusieurs lignes continues, l'étape de réglage comprend avantageusement une étape de comparaison de mesures de la propriété électrique aux bornes de plusieurs lignes continues.

Le réglage peut ensuite comprendre une étape de détermination d'un déplacement relatif de commande entre la source et/ou la au moins une portion d'au moins un composant optique des moyens d'acheminement par rapport à la zone active à partir d'un résultat obtenu au cour des opérations de calcul de variation et/ou de comparaison ainsi qu'une étape de déplacement relatif de la source et/ou la au moins une portion d'au moins un composant optique des moyens d'acheminement par rapport à la zone active du déplacement relatif de commande.

Avantageusement, le procédé comprend une étape de réglage de la position de la zone d'interaction dans le plan de la zone active de sorte à centrer sensiblement la zone d'interaction ZI sur le centre O suivie d'une étape de réglage de la focalisation du faisceau optique sensiblement sur le plan de la zone active. Cette deuxième étape peut être suivie d'une autre étape de réglage de la position de la zone d'interaction dans le plan de la zone active de sorte à centrer sensiblement la zone d'interaction ZI sur le centre O car cette première étape a pu être imprécise si le faisceau était initialement très défocalisé.

Le dispositif de réglage est avantageusement configuré pour mettre en œuvre ce procédé.

L'organe de commande peut comprendre un ou plusieurs circuits électroniques dédiés ou un circuit à usage général. Chaque circuit électronique peut comprendre une machine de calcul reprogrammable (un processeur ou un micro-contrôleur par exemple) et/ ou un calculateur exécutant un programme comprenant une séquence d'instructions et/ou une machine de calcul dédiée (par exemple un ensemble de portes logiques comme un FPGA un DSP ou un ASIC, ou tout autre module matériel).

## Revendications

1. Commutateur (COM) comprenant un substrat semi-conducteur (SUB) et une ligne hyperfréquence (10) comprenant deux pistes conductrices (11, 12) réalisées sur le substrat, les deux pistes conductrices (11, 12) étant séparées par un gap assurant une isolation électrique entre les deux pistes conductrices (11, 12), une zone active (ZA) du substrat étant délimitée par les deux pistes conductrices (11, 12) et reliant les deux pistes conductrices (11, 12), la zone active (ZA) étant planaire, définissant un plan de la zone active (ZA) et présentant un centre O, le substrat (SUB) étant apte à être rendu localement conducteur lorsque la zone active (ZA) est éclairée par un faisceau optique de commande de sorte à établir un contact électrique entre les deux pistes (11, 12) de la ligne hyperfréquence (10), **caractérisé en ce que** le commutateur comprend en outre un ensemble d'au moins une ligne, dite ligne continue (15, 16, 17, 18), destinée à acheminer un courant continu, la ligne continue comprenant deux électrodes distantes l'une de l'autre de sorte qu'une isolation électrique est assurée entre les deux électrodes, les électrodes étant reliées par une zone de séparation (160) du substrat, la zone de séparation étant apte à être rendue conductrice lorsqu'elle est éclairée par le faisceau optique de commande de sorte à établir un contact électrique entre les deux électrodes, les deux électrodes étant séparées par un plan de séparation (P) de la ligne continue, le plan de séparation (P) passant par le centre O et étant perpendiculaire au plan de la zone active (ZA).

2. Commutateur selon la revendication précédente, dans lequel les deux électrodes comprennent chacune une terminaison, dite terminaison centrale, de la ligne continue, les terminaisons centrales des deux électrodes de la ligne continue étant disposées en regard l'une de l'autre sur une droite, dite droite d'alignement.

3. Commutateur selon la revendication 2, dans lequel la droite d'alignement de la ligne continue est perpendiculaire au plan de séparation (P) de la ligne continue de façon symétrique par rapport au plan de séparation (P) de la ligne continue.

4. Commutateur selon la revendication précédente, dans lequel l'ensemble comprend deux lignes continues dont les droites d'alignement respectives sont perpendiculaires entre elles.

5. Commutateur selon l'une quelconque des revendications 2 à 4, dans lequel l'ensemble comprend plusieurs lignes continues, l'ensemble comprenant un sous-ensemble de deux lignes continues présentant le même plan de séparation (P), les terminaisons centrales de chacune des deux lignes continues étant disposées de façon symétrique par rapport au plan de séparation (P), sur une droite d'alignement perpendiculaire au plan de séparation (P), les droites d'alignement des deux lignes étant disposées de façon symétrique par rapport à un autre plan (P') passant par le centre (O), perpendiculaire au plan de la zone active (ZA) et perpendiculaire au plan de séparation (P).

6. Commutateur selon l'une quelconque des revendications 2 à 5, dans lequel l'ensemble comprend un premier sous-ensemble d'au moins une ligne continue et un deuxième sous-ensemble d'au moins une ligne continue, les terminaisons centrales des électrodes des lignes continues du premier et du deuxième sous-ensembles étant disposées sur des cercles concentriques dont le centre est situé sur un axe perpendiculaire au plan de la zone active (ZA) et passant par le centre O.

7. Commutateur selon la revendication précédente, dans lequel le plan de séparation (P) de la ligne continue du premier sous-ensemble est le plan de séparation (P) de la ligne continue du deuxième sous-ensemble, les deux terminaisons centrales de la ligne continue du premier sous-ensemble étant disposées de l'autre côté d'un autre plan (P'), passant par le centre O, perpendiculaire au plan de la zone active et perpendiculaire au plan de séparation (P), par rapport aux terminaisons centrales de la ligne continue du deuxième sous-ensemble.

8. Commutateur selon l'une quelconque des revendications 2 à 7, dans lequel la droite d'alignement d'au moins une ligne continue de l'ensemble de lignes continues passe par un axe perpendiculaire au plan de la zone active et passant par le centre O.

9. Commutateur selon l'une quelconque des revendications précédentes, dans lequel la zone active (ZA) et la zone de séparation (160) sont réalisées dans des matériaux différents.

10. Commutateur selon la revendication précédente, dans lequel la zone active (ZA) comprend des porteurs de durée de vie inférieure à une durée de vie des porteurs de la zone de séparation (160).

11. Procédé de fabrication d'un commutateur selon l'une quelconque des revendications précédentes, ledit procédé comprenant les étapes de disposer les pistes conductrices sur le substrat de façon qu'elles soient séparées par le gap, et de façon qu'elles délimitent et soient reliées par la zone active, et de disposer les électrodes de la ligne continue sur le substrat de façon qu'elles soient distantes l'une de l'autre de sorte qu'une isolation électrique est assurée entre les deux électrodes et de sorte qu'elles soient reliées par la zone de séparation (160) du substrat, et séparées par le plan de séparation (P).

12. Dispositif de commutation comprenant un commutateur selon l'une quelconque des revendications 1 à 10, comprenant une source générant le faisceau optique de commande et/ou des moyens d'acheminement comprenant au moins un composant optique permettant d'acheminer le faisceau optique de commande jusqu'à la zone active (ZA).

13. Dispositif de commutation selon la revendication précédente, comprenant un dispositif d'actionnement permettant de modifier une position de la source optique et/ou d'au moins une partie d'au moins un composant optique des moyens d'acheminement par rapport à la zone active (ZA).

14. Dispositif de commutation selon l'une quelconque des revendications 12 à 13, comprenant au moins un capteur permettant de mesurer une propriété électrique de la zone de séparation (160) entre des terminaisons centrales des deux électrodes de la ligne continue, le dispositif de réglage étant apte à régler une position de la source optique et/ou d'au moins une partie d'au moins un composant optique des moyens d'acheminement par rapport à la zone active (ZA) à partir d'au moins une mesure de la propriété électrique.

15. Dispositif de commutation selon la revendication 14, configuré pour mettre en œuvre une étape d'alignement lorsqu'une condition de mise en œuvre de l'étape d'alignement est respectée, le dispositif de commutation étant configuré pour mettre en œuvre les étapes suivantes lors de la mise en œuvre de l'étape d'alignement:
- mesurer la propriété électrique de la zone de séparation entre les terminaisons centrales de la ligne continue au moyen du capteur,
- régler la position de la source et/ou d'au moins une partie d'au moins un composant optique des moyens d'acheminement relativement à la zone active (ZA) à partir d'une mesure de la propriété électrique issue du capteur, au moyen du dispositif de réglage.

16. Procédé d'alignement de la source et/ou d'au moins une partie d'au moins un composant optique des moyens d'acheminement par rapport à la zone active (ZA) d'un dispositif de commutation selon la revendication 12, ledit procédé comprenant les étapes suivantes :
- mesurer la propriété électrique de la zone de séparation entre les terminaisons centrales de la ligne continue,
- régler la position de la source et/ou d'au moins une partie d'au moins un composant optique des moyens d'acheminement relativement à la zone active (ZA) à partir de ladite mesure.

## Patentansprüche

1. Umschalter (COM), beinhaltend ein Halbleitersubstrat (SUB) und eine Hyperfrequenzleitung (10), beinhaltend zwei auf dem Substrat geschaffene leitfähige Spuren (11, 12), wobei die zwei leitfähigen Spuren (11, 12) durch einen Spalt getrennt sind, welcher eine elektrische Isolation zwischen den beiden leitfähigen Spuren (11, 12) gewährleistet, wobei ein aktiver Bereich (ZA) des Substrates durch die beiden leitfähigen Spuren (11, 12) abgegrenzt wird und die beiden leitfähigen Spuren (11, 12) verbindet, wobei der aktive Bereich (ZA) planar ist, eine Ebene des aktiven Bereichs (ZA) definiert, und einen Mittelpunkt O aufweist, wobei das Substrat (SUB) in der Lage ist, lokal leitfähig gemacht zu werden, wenn der aktive Bereich (ZA) durch einen optischen Steuerstrahl in einer Weise beleuchtet wird, dass ein elektrischer Kontakt zwischen den beiden Spuren (11, 12) der Hyperfrequenzleitung (10) hergestellt wird, **dadurch gekennzeichnet, dass** der Umschalter zudem eine Gruppe aus mindestens einer Leitung beinhaltet, genannt durchgehende Leitung (15, 16, 17, 18), welche dazu bestimmt, ist einen Gleichstrom zu transportieren, wobei die durchgehende Leitung zwei voneinander entfernte Elektroden in einer Weise beinhaltet, dass eine elektrische Isolation zwischen den beiden Elektroden gewährleistet ist, wobei die Elektroden durch einen Trennbereich (160) des Substrates verbunden sind, wobei der Trennbereich in der Lage ist, leitfähig gemacht zu werden, wenn er durch den optischen Steuerstrahl in einer Weise beleuchtet wird, dass ein elektrischer Kontakt zwischen den beiden Elektroden hergestellt wird, wobei die beiden Elektroden durch eine Trennebene (P) der durchgehenden Leitung getrennt sind, wobei die Trennebene (P) den Mittelpunkt O durchquert und rechtwinklig zur Ebene des aktiven Bereichs (ZA) verläuft.

2. Umschalter nach dem vorhergehenden Anspruch, bei welchem die beiden Elektroden jeweils einen Endabschnitt, den mittleren Endabschnitt genannt, der durchgehenden Leitung beinhalten, wobei die mittleren Endabschnitte der beiden Elektroden der durchgehenden Leitung einander gegenüber auf einer Geraden angeordnet sind, genannt Ausfluchtungsgerade.

3. Umschalter nach Anspruch 2, bei welchem die Ausfluchtungsgerade der durchgehenden Leitung rechtwinklig zur Trennebene (P) der durchgehenden Leitung symmetrisch zur Trennebene (P) der durchgehenden Leitung verläuft.

4. Umschalter nach dem vorhergehenden Anspruch, bei welchem die Gruppe zwei durchgehende Leitungen beinhaltet, deren jeweilige Ausfluchtungsgeraden zueinander rechtwinklig sind.

5. Umschalter nach einem der Ansprüche 2 bis 4, bei welchem die Gruppe mehrere durchgehende Leitungen beinhaltet, wobei die Gruppe eine Untergruppe von zwei durchgehenden Leitungen die die dieselbe Trennebene (P) aufweisen umfasst, wobei die mittleren Endabschnitte einer jeden der beiden durchgehenden Leitungen symmetrisch zur Trennebene (P) auf einer Ausfluchtungsgeraden angeordnet sind, welche rechtwinklig zur Trennebene (P) verläuft, wobei die Ausfluchtungsgeraden der beiden Leitungen symmetrisch zu einer anderen Ebene (P') angeordnet sind, welche den Mittelpunkt (O) durchquert, rechtwinklig zum aktiven Bereich (ZA) und rechtwinklig zur Trennebene (P).

6. Umschalter nach einem der Ansprüche 2 bis 5, bei welchem die Gruppe eine erste Untergruppe aus mindestens einer durchgehenden Leitung und eine zweite Untergruppe aus mindestens einer durchgehenden Leitung beinhaltet, wobei die mittleren Endabschnitte der Elektroden der durchgehenden Leitungen der ersten und der zweiten Untergruppe auf konzentrischen Kreisen angeordnet sind, deren Mittelpunkt auf einer Achse liegt, welche rechtwinklig zur Ebene des aktiven Bereichs (ZA) verläuft und den Mittelpunkt O durchquert.

7. Umschalter nach dem vorhergehenden Anspruch, bei welchem die Trennebene (P) der durchgehenden Leitung der ersten Untergruppe die Trennebene (P) der durchgehenden Leitung der zweiten Untergruppe ist, wobei die beiden mittleren Endabschnitte der durchgehenden Leitung der ersten Untergruppe auf der anderen Seite einer Ebene (P') angeordnet sind, welche den Mittelpunkt O durchquert, rechtwinklig zur Ebene des aktiven Bereichs und rechtwinklig zur Trennebene (P) in Bezug auf die mittleren Endabschnitte der durchgehenden Leitung der zweiten Untergruppe.

8. Umschalter nach einem der Ansprüche 2 bis 7, bei welchem die Ausfluchtungsgerade mindestens einer durchgehenden Leitung der Gruppe von durchgehenden Leitungen eine Achse durchquert, welche rechtwinklig zur Ebene des aktiven Bereichs ist und den Mittelpunkt O durchquert.

9. Umschalter nach einem der vorhergehenden Ansprüche, bei welchem der aktive Bereich (ZA) und der Trennbereich (160) aus unterschiedlichen Materialien bestehen.

10. Umschalter nach dem vorhergehenden Anspruch, bei welchem der aktive Bereich (ZA) Träger mit einer Lebensdauer beinhaltet, welche geringer als eine Lebensdauer von Trägern des Trennbereichs (160) ist.

11. Verfahren zur Herstellung eines Umschalters nach einem der vorhergehenden Ansprüche, wobei das Verfahren die Schritte des Anordnens der leitfähigen Spuren auf dem Substrat in einer Weise beinhaltet, dass sie durch den Spalt getrennt sind, und in einer Weise, dass sie den aktiven Bereich begrenzen und durch diesen verbunden sind, und des Anordnens der Elektroden der durchgehenden Leitung auf dem Substrat in einer Weise, dass sie voneinander entfernt sind, so dass eine elektrische Isolation zwischen den beiden Elektroden gewährleistet ist und dass sie durch den Trennbereich (160) des Substrates verbunden und durch die Trennebene (P) getrennt sind.

12. Umschaltvorrichtung, beinhaltend einen Umschalter nach einem der Ansprüche 1 bis 10, beinhaltend eine Quelle, welche den optischen Steuerstrahl erzeugt und/oder Transportmittel, welche mindestens eine optische Komponente enthalten, welche es ermöglicht, den optischen Steuerstrahl bis zum aktiven Bereich (ZA) zu transportieren.

13. Umschaltvorrichtung nach dem vorhergehenden Anspruch, beinhaltend eine Betätigungsvorrichtung, welche es ermöglicht, eine Position der optischen Quelle und/oder mindestens eines Teils mindestens einer optischen Komponente der Transportmittel in Bezug auf den aktiven Bereich (ZA) zu verändern.

14. Umschaltvorrichtung nach einem der vorhergehenden Ansprüche 12 bis 13, beinhaltend mindestens einen Sensor, welcher es ermöglicht, eine elektrische Eigenschaft des Trennbereichs (160) zwischen mittleren Endabschnitten der beiden Elektroden der durchgehenden Leitung zu messen, wobei die Einstellvorrichtung in der Lage ist, eine Position der optischen Quelle und/oder mindestens eines Teils mindestens einer optischen Komponente der Transportmittel in Bezug auf den aktiven Bereich (ZA) anhand mindestens einer Messung der elektrischen Eigenschaft einzustellen.

15. Umschaltvorrichtung nach Anspruch 14, welche konfiguriert ist, um einen Schritt des Ausfluchtens umzusetzen, wenn eine Umsetzungsbedingung des Ausfluchtungsschrittes erfüllt ist, wobei die Umschaltvorrichtung konfiguriert ist, um die folgenden Schritte bei der Umsetzung des Ausfluchtungsschrittes umzusetzen:
- Messen der elektrischen Eigenschaft des Trennbereichs zwischen den mittleren Endabschnitten der durchgehenden Leitung mithilfe des Sensors,
- Einstellen der Position der Quelle und/oder mindestens eines Teils mindestens einer optischen Komponente der Transportmittel in Bezug auf den aktiven Bereich (ZA) anhand einer von dem Sensor stammenden Messung der elektrischen Eigenschaft, mithilfe der Einstellvorrichtung.

16. Verfahren zum Ausfluchten der Quelle und/oder mindestens eines Teils mindestens einer optischen Komponente der Transportmittel in Bezug auf den aktiven Bereich (ZA) einer Umschaltvorrichtung nach Anspruch 12, wobei das Verfahren folgende Schritte beinhaltet:
- Messen der elektrischen Eigenschaft des Trennbereichs zwischen den mittleren Endabschnitten der durchgehenden Leitung,
- Einstellen der Position der Quelle und/oder mindestens eines Teils mindestens einer optischen Komponente der Transportmittel in Bezug auf den aktiven Bereich (ZA) anhand der Messung.

## Claims

1. Switch (COM) comprising a semiconductor substrate (SUB) and a microwave line (10) comprising two conductive tracks (11, 12) produced on the substrate, the two conductive tracks (11, 12) being separated by a gap assuring an electrical isolation between the two conductive tracks (11, 12), an active zone (ZA) of the substrate being bounded by the two conductive tracks (11, 12) and connecting the two conductive tracks (11, 12), the active zone (ZA) being planar, defining a plane of the active zone (ZA), and having a centre O, the substrate (SUB) being able to be made locally conductive when the active zone (ZA) is illuminated by an optical control beam so as to establish an electrical contact between the two tracks (11, 12) of the microwave line (10), **characterized in that** the switch furthermore comprises a set of at least one line, called the DC line (15, 16, 17, 18), intended to convey a DC current, the DC line comprising two electrodes that are distant from each other so that an electrical isolation is assured between the two electrodes, the electrodes being connected by a separation zone (160) of the substrate, the separation zone being able to be made conductive when it is illuminated by the optical control beam so as to establish an electrical contact between the two electrodes, the two electrodes being separated by a separation plane (P) of the DC line, the separation plane (P) passing through the centre O and being perpendicular to the plane of the active zone (ZA).

2. Switch according to the preceding claim, wherein the two electrodes each comprise a terminal called the central terminal of the DC line, the central terminals of the two electrodes of the DC line being placed facing each other on a straight line called the alignment straight line.

3. Switch according to Claim 2, wherein the alignment straight line of the DC line is perpendicular to the separation plane (P) of the DC line symmetrically with respect to the separation plane (P) of the DC line.

4. Switch according to the preceding claim, wherein the set comprises two DC lines the respective alignment straight lines of which are perpendicular to each other.

5. Switch according to any one of Claims 2 to 4, wherein the set comprises a plurality of DC lines, the set comprising a subset of two which have the same separation plane (P), the central terminals of each of the two DC lines being placed symmetrically with respect to the separation plane (P) on an alignment straight line perpendicular to the separation plane (P), the alignment straight lines of the two lines are placed symmetrically with respect to another plane (P') passing through the centre (O), perpendicular to the plane of the active zone (ZA) and perpendicular to the separation plane (P).

6. Switch according to any one of Claims 2 to 5, wherein the set comprises a first subset of at least one DC line and a second subset of at least one DC line, the central terminals of the electrodes of the DC lines of the first and second subsets being placed on concentric circles the centre of which is located on an axis perpendicular to the plane of the active zone (ZA) and passing through the centre O.

7. Switch according to the preceding claim, wherein the separation plane (P) of the DC line of the first subset is the separation plane (P) of the DC line of the second subset, the two central terminals of the DC line of the first subset being placed on the other side of another plane (P') passing through the centre O, perpendicular to the plane of the active zone and perpendicular to the separation plane (P) with respect to the central terminals of the DC line of the second subset.

8. Switch according to any one of Claims 2 to 7, wherein the alignment straight line of at least one DC line of the set of DC lines passes through an axis perpendicular to the plane of the active zone and passing through the centre O.

9. Switch according to any one of the preceding claims, wherein the active zone (ZA) and the separation zone (160) are made from different materials.

10. Switch according to the preceding claim, wherein the active zone (ZA) comprises carriers of lifetime lower than a lifetime of the carriers of the separation zone (160).

11. Process for fabricating a switch according to any one of the preceding claims, said process comprising the steps of placing the conductive tracks on the substrate so that they are separated by the gap, and so that they bound and are connected by the active zone, and placing the electrodes of the DC line on the substrate so that they are distant from each other so that an electrical isolation is assured between the two electrodes and so that they are connected by the separation zone (160) of the substrate, and separated by the separation plane (P).

12. Switching device comprising a switch according to any one of Claims 1 to 10, comprising a source generating the optical control beam and/or conveying means comprising at least one optical component allowing the optical control beam to be conveyed to the active zone (ZA).

13. Switching device according to the preceding claim, comprising an actuating device allowing a position of the optical source and/or of at least one part of at least one optical component of the conveying means to be modified with respect to the active zone (ZA).

14. Switching device according to any one of Claims 12 to 13, comprising at least one sensor allowing an electrical property of the separation zone (160) between central terminals of the two electrodes of the DC line to be measured, the adjusting device being able to adjust a position of the optical source and/or of at least one part of at least one optical component of the conveying means with respect to the active zone (ZA) on the basis of at least one measurement of the electrical property.

15. Switching device according to Claim 14, configured to implement an aligning step when a condition of implementation of the aligning step is met, the switching device being configured to implement the following steps during the implementation of the aligning step:
- measuring the electrical property of the separation zone between the central terminals of the DC line by means of the sensor,
- adjusting the position of the source and/or of at least one part of at least one optical component of the conveying means relatively to the active zone (ZA) on the basis of a measurement of the electrical property issued from the sensor, by means of the adjusting device.

16. Method for aligning the source and/or at least one part of at least one optical component of the conveying means with respect to the active zone (ZA) of a switching device according to Claim 12, said method comprising the following steps:
- measuring the electrical property of the separation zone between the central terminals of the DC line,
- adjusting the position of the source and/or of at least one part of at least one optical component of the conveying means relatively to the active zone (ZA) on the basis of said measurement.
